(19) Europäisches Patentamt European Patent Office Office européen des brevets

(11) **EP 4 310 844 B1**

(12) **EUROPEAN PATENT SPECIFICATION**

(45) Date of publication and mention
of the grant of the patent:
**09.04.2025  Bulletin 2025/15**

(21) Application number: **23172521.9**

(22) Date of filing: **10.05.2023**

(51) International Patent Classification (IPC):
*G11C 7/10* (2006.01)      *G11C 7/12* (2006.01)
*G11C 11/419* (2006.01)     *G11C 11/54* (2006.01)

(52) Cooperative Patent Classification (CPC):
**G11C 11/419; G11C 7/1006; G11C 7/12;
G11C 11/54**

(54) **MEMORY DEVICE AND METHOD WITH IN-MEMORY COMPUTING**

SPEICHERVORRICHTUNG UND VERFAHREN MIT SPEICHERINTERNER BERECHNUNG

DISPOSITIF DE MÉMOIRE ET PROCÉDÉ AVEC CALCUL EN MÉMOIRE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **19.07.2022  KR 20220088942
01.11.2022  KR 20220143480**

(43) Date of publication of application:
**24.01.2024  Bulletin 2024/04**

(73) Proprietor: **Samsung Electronics Co., Ltd.
Suwon-si, Gyeonggi-do 16677 (KR)**

(72) Inventors:
• **Lee, Jaehyuk
Suwon-si, Gyeonggi-do 16678 (KR)**

• **Yun, Seok Ju
Suwon-si, Gyeonggi-do 16678 (KR)**
• **Chang, Dong-Jin
Suwon-si, Gyeonggi-do 16678 (KR)**
• **Myung, Sungmeen
Suwon-si, Gyeonggi-do 16678 (KR)**
• **Yoon, Daekun
Suwon-si, Gyeonggi-do 16678 (KR)**

(74) Representative: **Grünecker Patent- und
Rechtsanwälte
PartG mbB
Leopoldstraße 4
80802 München (DE)**

(56) References cited:
**CN-A- 114 613 404      US-A1- 2009 086 528
US-A1- 2012 195 111     US-B1- 11 176 991**

**Description**

BACKGROUND

1. Field

The following description relates to a memory device with in-memory computing (IMC).

2. Description of Related Art

A vector-matrix multiplication operation, which is also known as a multiply-accumulate (MAC) operation, may be central to the performance of applications in various technical fields. For example, the MAC operation may be performed for machine learning and authentication of a multi-layer neural network. An input signal may be considered to form an input vector and may be data of images, byte streams, or other datasets to be processed by a neural network, for example. The input signal may be multiplied by a weight of an input layer of a neural network, for example, and an output vector may be obtained from an accumulated MAC operation result. The output vector may be provided as an input vector for a subsequent layer of the neural network. The MAC operation may be iteratively performed in a sequence of layers, and the processing performance of the neural network may thus be determined mainly by the performance of the MAC operation. The MAC operation may be implemented through in-memory computing (IMC).

CN 114,613,404 A refers to memory computing. A compute-in-memory, CIM, device has a memory array including a plurality of memory cells arranged in rows and columns. The plurality of memory cells includes first memory cells in a first row and a first column of the memory array, and second memory cells in a first row and a second column of the memory array. The first and second storage units are configured to store respective first and second weight signals. The input driver provides a plurality of input signals. The first logic circuit is coupled to the first memory cell to provide a first output signal based on a first weight signal and a first input signal from the input driver. A second logic circuit is coupled to the second memory cell to provide a second output signal based on a second weight signal and a second input signal from the input driver.

US 2009/086528 A1 refers to methods, devices and systems for a back gated static random access memory, SRAM, cell. Operation of an SRAM cell includes applying a potential to a back gate of a pair of cross-coupled p-type pull up transistors in the SRAM during a write operation. The method includes applying a ground to the back gate of the pair of cross-coupled p-type pull up transistors during a read operation. The charge stored on a pair of cross-coupled storage nodes of the SRAM is coupled to a front gate and a back gate of a pair of cross-coupled n-type pull down transistors in the SRAM during the write operation and during a read operation.

US 11,176,991 B1 refers to compute-in-memory, CIM, circuits employing static random access memory, SRAM, bit cells. The CIM circuits can be used for multiply-and-accumulate, MAC, operations. The CIM circuits can include five-transistor, 5T, SRAM bit cells that each have a single bit line coupled to an access circuit for accessing the SRAM bit cell for read/write operations. The CIM circuit also includes a multiplication circuit coupled to the SRAM bit cell. The CIM circuit is configured to perform multiplication of an input data value received by the multiplication circuit with a weight data value stored in the SRAM bit cell.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is claimed in the independent claims. Preferred embodiments are specified in the dependent claims.

According to an aspect of the present invention, there is provided a memory device. The memory device comprises a multiplying cell comprising a memory cell in which a value is stored, wherein the memory cell comprises a pair of inverters comprising a first inverter and a second inverter, each inverter comprising an input and an output, wherein the input of the first inverter is connected to the output of the second inverter at a first end of the pair of inverters, and wherein the output of the first inverter is connected to the input of the second inverter at a second end of the pair of inverters, a first transistor connected to the first end of the pair of inverters, and a second transistor connected to the second end of the pair of inverters; and a switching element configured as a pull-up transistor and connected to an output end of the memory cell, the pull-up transistor configured to select one operation from between a first operation and a second operation and perform the selected operation, and to perform switching in response to an input value and output a signal corresponding to a multiplication result between the input value and the stored value. The first operation comprises driving a voltage at an output end of the pull-up transistor to a supply voltage in response to a voltage less than the supply voltage being applied through a word line in some multiplication operations in a series of multiplication operations, and outputting each time a multiplication operation result according to an input supplied to the memory device, and the second operation comprises driving a voltage at the output end of the pull-up transistor to the supply voltage in a pre-charge phase for each multiplication operation, and performing a multiplication operation in an evaluation phase.

The switching element may be configured to, when connected between a supply voltage and the output end of the memory cell: be turned off in response to a logic value of one being received as the input value, and be turned on in response to a logic value of zero being received as the input value.

The switching element may be configured as a pull-up transistor configured to receive the input value at a gate terminal.

The first transistor and the second transistor may each be an N-type metal-oxide-semiconductor (NMOS) transistor, and wherein the pull-up transistor may be a P-type metal-oxide-semiconductor (PMOS) transistor.

The memory device may be further configured to select the one operation from between the first operation and the second operation based on either an operating frequency of the memory device or a leakage.

The memory device may further include an adder connected to an output end of the multiplying cell and configured to add an inverse value of a signal output from the multiplying cell.

The memory device may further include a global bit line and switch for a read operation or a write operation on the weight of the memory cell through access to the memory cell of the multiplying cell.

The multiplying cell may include memory cells connected to the same pull-up transistor.

The memory device may further include an input/word line driver configured to select, from among the memory cells, a memory cell to be used for a target multiplication operation.

The input/word line driver may include a decoding circuit configured to decode an input value provided to the multiplying cell from an input signal and from a signal designating the memory cell to be used for the target multiplication operation.

The memory device may be further configured to activate a word line connected to a memory cell storing a value corresponding to a target operation among memory cells included in one multiplication cell, and deactivate a word line connected to a memory cell, among the memory cells, other than the memory cell of the activated word line.

The memory device may be further configured to select a first memory cell from among the memory cells for a first operation among a plurality of operations and output a signal corresponding to a multiplication result through the same pull-up transistor, and select a second memory cell from among the memory cells for a second operation among the plurality of operations and output a signal corresponding to a multiplication result through the same pull-up transistor.

The memory device may further include multiplying cells including the multiplying cell, and may be configured to perform a multiplication operation in each of the multiplying cells in parallel with other multiplying cells, and add, in the same adder, outputs of multiplying cells connected to the same column line among the plurality of multiplying cells.

The multiplying cell may be connected to a pair of local bit lines, a first memory cell among memory cells included in the multiplying cell may be connected to a first local bit line, and a second memory cell among the plurality of memory cells may be connected to a second local bit line.

The first memory cell may be connected to the first local bit line and may have a value corresponding to a weight of a neural network, and the second memory cell connected to the second local bit line may have an inverse value of the weight.

The memory device may further include an accumulator configured to store an output of an adder configured to add multiplication results of the multiplying cell, and accumulate results of the adding.

The memory device may further include an output register configured to store a final multiplication operation result output from the accumulator.

The memory device may be further configured to, when receiving an input signal corresponding to a last bit of a single bit or multiple bits, store an accumulator operation result for the input signal in an output register.

The memory device may further include a memory controller configured to control the multiplying cell, an input/word line driver, a read/write circuit, an adder, an accumulator, and an output register.

The memory device may be further configured to, in response to either a preset period having elapsed or a multiplication operation using another memory cell being performed in each multiplying cell, perform an operation for a pre-charge on an output end of a pull-up transistor.

The memory device may further include a pull-up transistor having a gate and connected to an output line, and a cell transistor having a gate and connected to the first end of the pair of inverters and to the output line, and in response to an input having the same logic value being applied to the gate of the pull-up transistor and the gate of the cell transistor, configured to output, to the output line, a logic value corresponding to a binary multiplication result between the input and a binary value stored in the memory cell.

The logic value corresponding to the binary multiplication result may be a NAND result.

The pull-up transistor may be a P-type metal-oxide-semiconductor (PMOS) transistor, and the cell transistor may be an N-type metal-oxide-semiconductor (NMOS) transistor.

The multiplication result may be output every clock cycle.

The multiplication result may be output only every two clock cycles.

The cell transistor may be a first cell transistor, and the memory cell may further include a second cell transistor having a gate and connected to the second end of the pair of inverters, wherein an input having the same logic value is applied to the gate of the second cell transistor.

The output line may be a first output line further including a second output line.

The cell transistor may be a first cell transistor, and the memory cell may further include a second cell transistor having a gate and connected to the other end of the pair of inverters and to the second output line.

The pull-up transistor may be a first pull-up transistor, and the memory device may further include a second pull-up transistor connected to the second output line.

The memory cell may be one of multiple memory cells connected to the first output line and the second output line.

The memory cell may be one of multiple memory cells connected to the output line.

According to another aspect of the present invention, there is provided a method of operating a memory device. The method comprises receiving an input value through a word line by a memory cell comprising two inverters connected to each other in opposite directions relative to each other, and two transistors connected to both ends of the two inverters; receiving the input value at a gate terminal by a pull-up transistor connected to an output end of the memory cell; selecting, by the pull-up transistor, one operation from between a first operation and a second operation and performing the selected operation, and switching in response to an input value and output a signal corresponding to a multiplication result between the input value and the stored value; and outputting, from an output end of the pull-up transistor, a signal corresponding to a multiplication result between the input value and a weight stored in the memory cell, wherein the first operation comprises driving a voltage at an output end of the pull-up transistor to a supply voltage in response to a voltage less than the supply voltage being applied through a word line in some multiplication operations in a series of multiplication operations, and outputting each time a multiplication operation result according to an input supplied to the memory device, and wherein the second operation comprises driving a voltage at the output end of the pull-up transistor to the supply voltage in a pre-charge phase for each multiplication operation, and performing a multiplication operation in an evaluation phase.

Other features and aspects will be apparent from the following detailed description, the drawings, and the claims.

BRIEF DESCRIPTION OF THE DRAWINGS

FIG. 1 illustrates an example of an in-memory computing (IMC) system of a multiply-accumulate (MAC) operation of a neural network, according to one or more embodiments.

FIG. 2 illustrates an example structure of a memory device in an IMC system, according to one or more embodiments.

FIGS. 3A through 3F illustrate examples of a structure of a multiplying cell in a memory device, according to one or more embodiments.

FIG. 4 illustrates examples of an operation of a multiplying cell, according to one or more embodiments.

FIG. 5 illustrates an example of a memory device in which multiplying cells are arranged in an array structure, according to one or more embodiments.

FIGS. 6A and 6B illustrate example structure in which memory cells share a pull-up transistor in a multiplying cell, according to one or more embodiments.

FIG. 7 illustrates an example of a memory device in which the multiplying cell of FIG. 6A is arranged in an array structure, according to one or more embodiments.

FIG. 8 illustrates an example of outputting a multiplication result from a multiplying cell through a pair of local bit lines, according to one or more embodiments.

FIG. 9 illustrates an example of a memory device in which the multiplying cell of FIG. 8 is arranged in an array structure, according to one or more embodiments.

FIG. 10 illustrates an example of an operation method of a multiplying cell, according to one or more embodiments.

FIG. 11 illustrates an example of an operation method of a memory device, according to one or more embodiments.

FIG. 12 illustrates an example of implementation of a multiplying cell, according to one or more embodiments.

Throughout the drawings and the detailed description, unless otherwise described or provided, the same drawing reference numerals will be understood to refer to the same or like elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

Hereinafter, examples will be described in detail with reference to the accompanying drawings. When describing the examples with reference to the accompanying drawings, like reference numerals refer to like components and a repeated description related thereto is omitted.

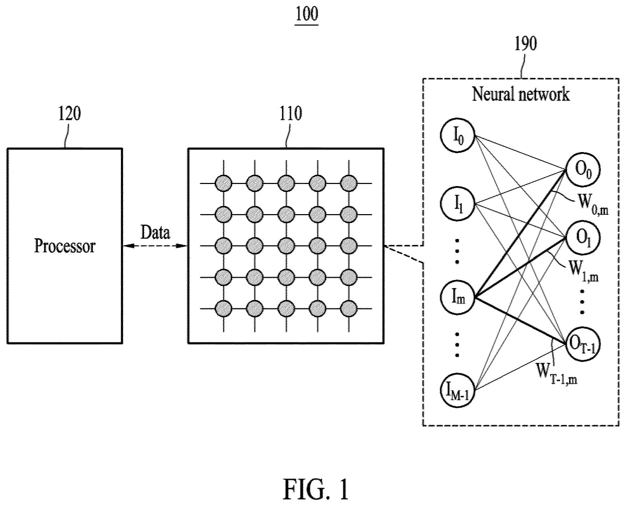

FIG. 1 illustrates an example of an in-memory computing (IMC) system of a multiply-accumulate (MAC) operation of a neural network, according to one or more embodiments.

In computing devices that use the von-Neumann architecture, there may be a limitation in performance and power due to frequent data movements between an operator portion (e.g., a main processor) and a memory portion. IMC, which is a computer architecture for performing computation operations (e.g., MAC operations) directly on data in a memory in which data is stored, may reduce the frequency of data movements between a processor 120 and an IMC memory device 110 and may increase power efficiency. In an IMC system 100, the processor 120 may input data (that is to be computed) into the memory device 110, and the IMC memory device 110 may perform an operation (or computation) by itself on the data. The processor 120 may read a result of the operation from the IMC memory device 110. Accordingly, data transmission during such a computation process may be minimized.

For example, the IMC system 100 may perform a MAC operation that is frequently used in an artificial intelligence (AI) algorithm and in various other kinds of operations. As illustrated in FIG. 1, a layer operation 190 in a neural network may include a MAC operation of adding results of multiplying, by a weight, each of input values of input nodes. The MAC operation may be represented by Equation 1, for example.

Equation 1

$$O_0 = \sum_{m=0}^{M-1} I_m W_{0,m}, O_1 = \sum_{m=0}^{M-1} I_m W_{1,m}, ..., O_{T-1} = \sum_{m=0}^{M-1} I_m W_{T-1,m}$$

In Equation 1, $O_t$ denotes an output to a t-th node, $I_m$ denotes an m-th input, and $W_{t,m}$ denotes a weight to be applied to the m-th input to be input to the t-th node. Ot, which is an output of a node or a node value of the node, may be calculated as a weighted sum of the input $I_m$ and the weight $W_{t,m}$. Here, m may be greater than or equal to zero (0) and less than or equal to M-1, t may be greater than or equal to 0 and less than or equal to T-1. M denotes the number of nodes of a previous layer connected to one node of a current layer (the current layer being a target to be computed) and T denotes the number of nodes of the current layer. According to an embodiment, the IMC memory device 110 of the IMC system 100 may perform the MAC operation described above with input data inputted to the IMC memory device 110 serving as one operand and with data stored in the IMC memory device 110 as another operand (e.g., weight data). The IMC memory device 110 may also be referred to as a resistive memory device, a memory array, or an IMC device.

IMC devices may be classified into analog IMC devices and digital IMC devices. Analog IMC devices may perform a MAC operation in an analog domain including a current, a charge, or a time domain. Digital IMC devices may perform a MAC operation using a logic circuit, for example. Digital IMC may be readily implemented by advanced processing and exhibit a desirable performance. According to an embodiment, the memory device 110 may have a static random-access memory (SRAM) unit for storing a bit, which may include a plurality of transistors (e.g., six transistors). The SRAM unit including six transistors may also be referred to as a 6T SRAM. The SRAM unit may store data as a logic value of 0 or 1 and may thus not require domain transformation. For example, the memory device 110 may include a multiplying cell in which a pull-up transistor and a memory cell (e.g., an SRAM cell) are combined. The multiplying cell may include multiple memory cells connected to one pull-up transistor, and thus the memory array of the memory device 110 may be implemented with a smaller number of transistors. Accordingly, the memory device 110 may have hardware with improved area efficiency and power efficiency by the multiplying cell. The memory device 110 is not limited to being used for a MAC operation, and the memory device 110 may be used to drive various algorithms that include memory storage and multiplication operations. A computing structure in which the memory device 110 directly performs an operation within its memory without an external data movement is described below.

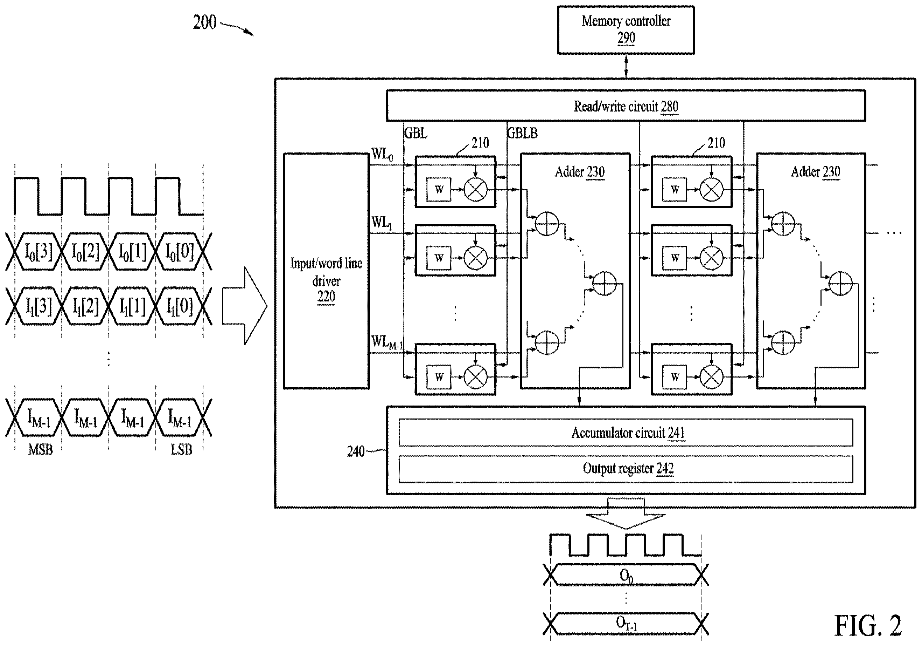

FIG. 2 illustrates an example of a structure of a memory device in an IMC system according to one or more embodiments.

According to an embodiment, a memory device 200 (e.g., the memory device 110 of FIG. 1) may include multiplying cells 210, an input/word line driver 220, adders 230, an outputter 240, a read/write circuit 280, and a memory controller 290. In a digital IMC system and/or circuit, an operation may be performed with all data represented as Boolean values, and an input value, a weight, and an output value may all have a binary format. The components described with reference to FIG. 2 may be implemented based on a digital logic circuit.

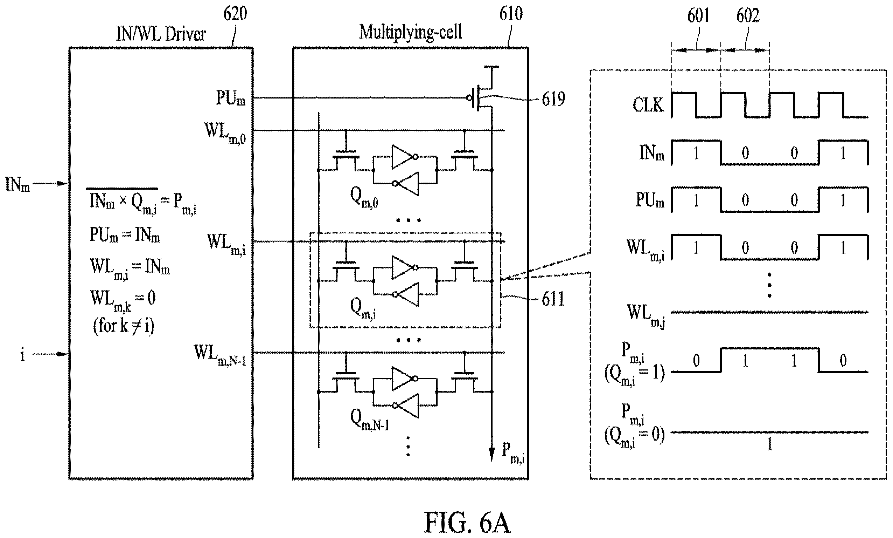

The input/word line driver 220 may transmit, to the multiplying cell 210, input data on which an operation is to be performed. The input/word line driver 220 may generate a pull-up signal and a word line signal to be applied to a memory cell of each multiplying cell 210 and a pull-up transistor. The pull-up signal and the word line signal may each be a signal that is determined based on an input value of input data, and will be described later with reference to FIG. 6A. The input data may be digital data having a multi-bit input value or a single-bit input value. The input/word line driver 220 may receive the input data from an external module (e.g., the processor 120 of FIG. 1). For example, in the case of the multi-bit input value, the input/word line driver 220 may sequentially transmit multi-bit values to the multiplying cell 210 for each bit position. For example, in the example illustrated in FIG. 2, the input/word line driver 220 may sequentially receive 4-bit input values from a least significant bit (LSB) to a most significant bit (MSB). When the memory device 200 operates for a neural network operation, the input/word line driver 220 may apply input values received from M nodes of a layer to word lines (e.g., $WL_0$, $WL_1$, ..., and $WL_{M-1}$). For example, an input value from an m-th node may be applied to $WL_m$, and the input value applied to $WL_m$ may be a multi-bit or single-bit value. In this example, m may be an integer greater than or equal to 0 and less than or equal to M-1, in which M may be an integer greater than or equal to 1. When the input value applied to $WL_m$ is a multi-bit value, bit values for each bit position may be sequentially transmitted to the multiplying cell 210 as described above. The input/word line driver 220 may individually transmit the M input values received from the nodes to M multiplying cells. As will be described later, each of the M multiplying cells may perform a multiplication operation in parallel with the other multiplying cells, and thus M multiplication operations may be performed in parallel for each output line (e.g., a column line).

For example, when a weight is a multi-bit value, output lines corresponding to the number of bits for representing the weight may be grouped. The grouped output lines may be collectively referred to as an output line group. For example, in a case of an X-bit weight, X output lines may be grouped, and the grouped X output lines may output multiplication sum results between an input value and the X-bit weight. In this example, X may be an integer greater than or equal to 2. For example, a first output line among the X output lines grouped into one group may output a multiplication result between a weight bit value corresponding to an LSB of the weight and an input bit value. For example, an x output line may output a multiplication result between a weight bit value at an x-1th bit position from the LSB and an input bit value. In this example, x may be an integer greater than or equal to 2 and less than or equal to X. In this example, an accumulator circuit 241 may apply bit shifting of a bit position corresponding to output lines of the same output line group to a sum of result outputs from the corresponding output line, and accumulate values to which the bit shifting is applied to output a final MAC operation result.

Also, when one multiplying cell 210 includes multiple memory cells, the input/word line driver 220 may select a memory cell storing a weight to be applied to received input data. The input/word line driver 220 may use a decoding unit (e.g., a decoding circuit) to extract a value indicating the memory cell storing the weight to be applied to the input data. Operation of a structure in which the multiplying cell 210 includes a plurality of memory cells is described with reference to FIG. 6A.

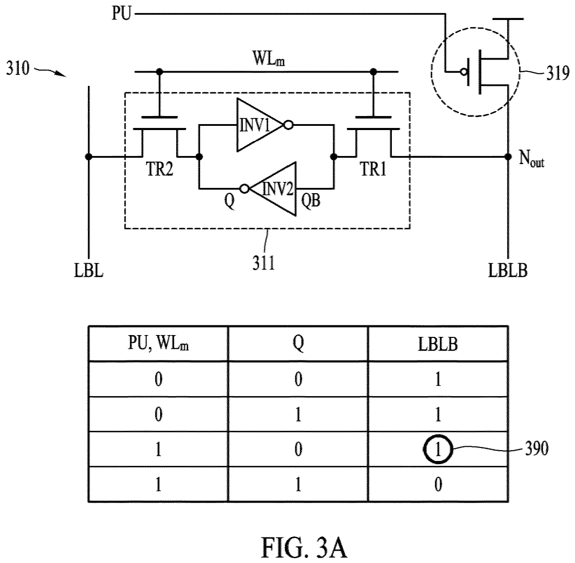

According to an embodiment, the multiplying cell 210 may perform a multiplication operation between a received input value and a weight stored in a memory cell. The multiplying cell 210 may output a signal corresponding to a multiplication result, through a structure in which the memory cell, a pull-up transistor, a word line WL, and a pull-up line PU are connected. For example, as described with reference to FIGS. 3A through 3F, the multiplying cell 210 may output a logic operation NAND result value between an input bit value and a weight value. The multiplication result may be a result value of a logic multiplication AND, and may correspond to an inverse value obtained by inverting the NAND result value. As will be described later, results output from the multiplying cell 210 may be inverted and added.

The adder 230 may have an input connected to an output end of the multiplying cell 210. The output end of the multiplying cell 210 may correspond to an output line. The output end of the multiplying cell 210 may be connected to one output line. The adder 230 may add an inverse value of a signal output from the multiplying cell 210. The adder 230 may add multiplication results of multiplying cells 210 connected to the same output line. The adder 230 may be implemented as a full adder, a half adder, and/or a flip-flop, and may be implemented as an adder tree circuit. In addition, as described above, an output result of the multiplying cell 210 may be a NAND result value, and thus the adder 230 may be implemented with the inclusion of an inverting function or an inverter (logical negation) for inverting the output result of each multiplying cell 210. The adder 230 may add inverted values (results) outputted by respective multiplying cells 210. The adder 230 may transmit a result of adding a plurality of multiplication results to the accumulator circuit 241. The adder 230 may be disposed on each output line. For example, when there are T output lines, T adders may be respectively disposed. In this example, T multiplication result sum values may be transmitted from the T adders to the accumulator circuit 241.

The outputter 240 may include the accumulator circuit 241 and an output register 242. The accumulator circuit 241 may output a final MAC operation result by combining results.

The accumulator circuit 241 (e.g., an accumulator) may store an output of the adder 230 (which adds multiplication results of multiplying cells 210) and may accumulate results of the adding. For example, when the input/word line driver 220 receives multi-bit input data (e.g., streamed to the memory device 200), the input/word line driver 220 may sequentially transmit a bit value for each bit position to each multiplying cell 210. Thus, each multiplying cell 210 may output a multiplication result value of a corresponding bit position. The adder 230 may transmit a result of adding multiplication result values of a corresponding bit position to the accumulator circuit 241. The accumulator circuit 241 may perform bit shifting on the adding result for the corresponding bit position. The accumulator circuit 241 may combine a bit-shifted adding result of an adding result for a subsequent bit position and may obtain an accumulated result of multiplication results for each bit position. As described later, when the input/word line driver 220 receives single-bit input data, bit shifting may not be required, and thus the accumulator circuit 241 may transmit the adding result of the adder 230 immediately to the output register 242.

The output register 242 may store a final multiplication operation result (e.g., a MAC result) output from the accumulator circuit 241. The final multiplication operation result (e.g., the MAC result) stored in the output register 242 may be read by the processor to be used for other operations. For example, when the memory device 200 is capable of performing only a MAC operation corresponding to some of the layers of a neural network at a time, a MAC result stored in the output register 242 may be transmitted to the input/word line driver 220 for an operation of a subsequent layer. The input/word line driver 220 of the memory device 200 may select a memory cell in which a weight set corresponding to the subsequent layer is set and may then perform a multiplication operation.

The weight set may be a set of weights by which an input is multiplied in one MAC operation. That is, the weight set and the input may be operands of the MAC operation. For example, the weight set may be a set of connection weights between nodes in one layer and nodes in another layer in a neural network. However, the weight set is not limited to a set of connection weights between nodes in a neural network, and a different weight set may be used for each task. Moreover, application of the memory device 200 is not limited to any particular type of input or stored data. For example, when a first weight set is required in a MAC operation for a first task, the memory device 200 may select a memory cell in which a weight included in the first weight set is stored from among memory cells included in a multiplying cell 210. Similarly, when a second weight set is required in a MAC operation for a second task, the memory device 200 may select a memory cell in which a weight included in the second weight set is set.

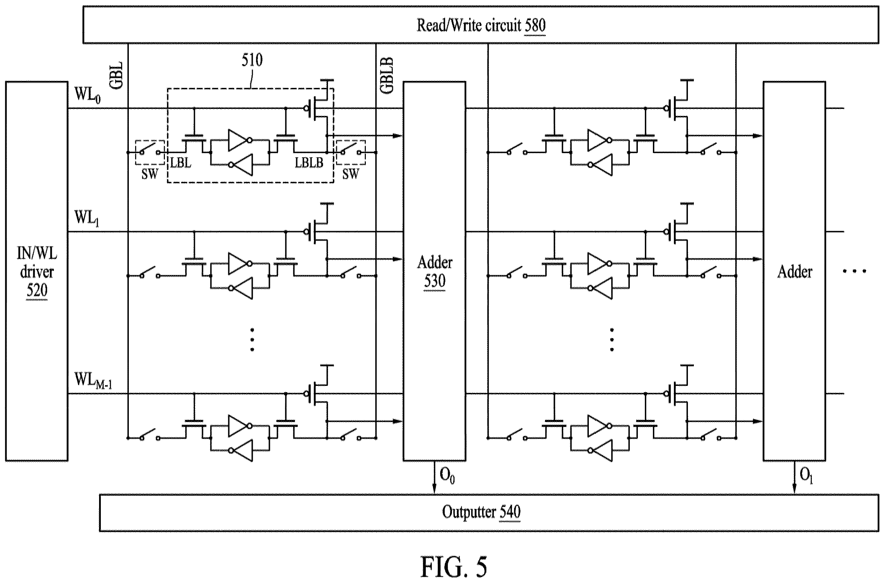

The read/write circuit 280 may read and write data of a memory cell included in a multiplying cell 210. The data of the memory cell may include, for example, a weight by which an input value is to be multiplied in a MAC operation. The read/write circuit 280 may access the memory cell of the multiplying cell 210 through a global bit line (e.g., a GBL and a GBLB as shown in FIG. 2). For example, when the multiplying cell 210 includes a plurality of memory cells, the read/write circuit 280 may access a memory cell connected to an activated word line among a plurality of word lines. The read/write circuit 280 may set (store) a weight for the accessed memory cell or read the set (stored) weight. The access through the global bit line (e.g., a GBL and a GBLB) will be described later with reference to FIG. 5.

The memory controller 290 may control the multiplying cells 210, the input/word line driver 220, the read/write circuit 280, the adders 230, the accumulator circuit 241, and the output register 242.

The memory device 200 may be implemented as a neural network device, an IMC circuit, and/or a MAC circuit or device. The memory device 200 may include area-efficient SRAM multiplying cells for IMC. The memory device 200 may receive an input value through a word line, and may output a signal (e.g., a NAND result signal) corresponding to a multiplication result between the input value and a weight stored in a 6T SRAM memory cell through a bit line. The memory device 200 may perform functions of a controller and a multiplier with a smaller number of transistors.

FIGS. 3A through 3F illustrate examples of structure of a multiplying cell in a memory device according to one or more embodiments.

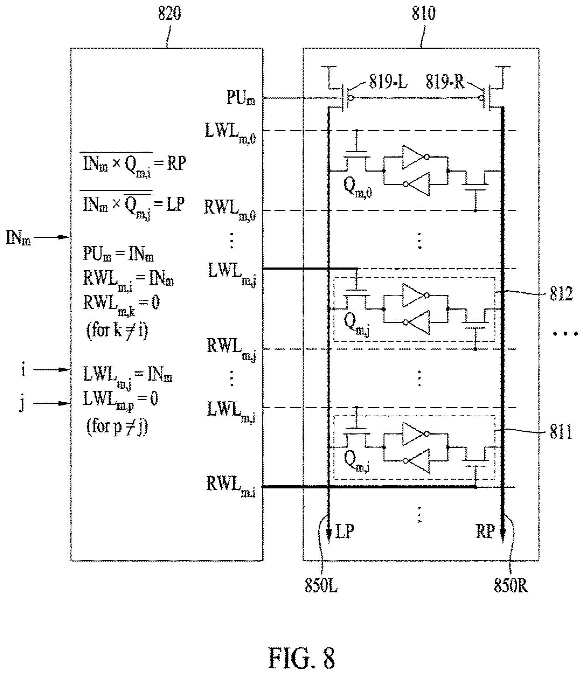

According to an embodiment, a multiplying cell 310 may perform a multiplication operation between an input value and a weight previously set/stored in a memory cell 311. Each multiplying cell 310 may include a memory cell 311 and a switching element 319 (e.g., a pull-up transistor). Each multiplying cell 310 may be connected to two local bit lines (e.g., an LBL and an LBLB), and one switching element 319 may be disposed on at least one of the two local bit lines. For example, each multiplying cell 310 may include only one switching element 319 on one of the two local bit lines. In the examples illustrated in FIGS. 3A to 3E, a single switching element 319 may be disposed on a first local bit line (LBLB), and no switching element 319 may be disposed on a second local bit line (LBL). In the example to be described later with reference to FIG. 8, one switching element 319 may be disposed on each of the two local bit lines (LBL and LBLB).

According to an embodiment, the memory cell 311 may have a set/stored weight. The memory cell 311 may selectively provide a weight-based signal to an output line in response to an input value. For example, when receiving a first logic value (e.g., a logic value of 0 or L) through a word line, the memory cell 311 may be disconnected from the output line. When receiving a second logic value (e.g., a logic value of 1 or H) through the word line, the memory cell 311 may provide a weight-based signal (e.g., a signal indicating an inverse value (QB) of a logic value of a set/stored weight) to the output line.

The memory cell 311 includes two inverters INV1 and INV2 and a cell transistor (e.g., a first transistor TR1). The cell transistor may have a gate and may be connected to one end of the pair of inverters INV1 and INV2 and to the output line. Two transistors (e.g., cell transistors) may be connected to both ends of the two inverters INV1 and INV2, . For example, the pair of inverters INV1 and INV2 may be connected in opposite directions. A memory device may include multiple memory cells connected to the output line.

The inverters INV1 and INV2 may be paired at respective ends thereof. The first transistor TR1 (e.g., a first cell transistor) may be connected to one end of the pair of inverters INV1 and INV2. A second transistor TR2 (e.g., a second cell transistor) may be connected to the other end of the pair of inverters INV1 and INV2. The memory cell 311 may be configured with six transistors including the two inverters INV1 and INV2, the first transistor TR1, and the second transistor TR2. The memory cell 311 may be an SRAM implemented with six transistors. The value QB, obtained by inverting the weight, may be set at one end of the pair of inverters INV1 and INV2. The weight may be set at the other end of the pair of inverters INV1 and INV2 in the memory cell 311. A gate terminal of the first transistor TR1 and the second transistor TR2 may be connected to a word line $WL_m$. One end of the first transistor TR1 may be connected to the first local bit line LBLB, and the other end of the first transistor TR1 may be connected to the pair of inverters INV1 and INV2. One end of the second transistor TR2 may be connected to the second local bit line LBL, and the other end of the second transistor TR2 may be connected to the pair of inverters INV1 and INV2. The cell transistors (e.g., the first transistor TR1 and the second transistor TR2) may each be a N-type metal-oxide-semiconductor (NMOS) transistor. An input having the same logic value may be applied to a gate of a pull-up transistor, a gate of the first cell transistor, and a gate of the second cell transistor. The first cell transistor may be connected to the first output line (e.g., the first local bit line LBLB), and the second cell transistor may be connected to the second output line (e.g., the second local bit line LBL).

The switching element 319 is connected to an output end $N_{out}$ of the memory cell 311. The switching element 319 may output a signal corresponding to a multiplication result between an input value and a weight by performing switching in response to the input value. The switching element 319 may be connected between a supply voltage $V_{DD}$ and the output end $N_{out}$ of the memory cell 311. The switching element 319 may be turned off when receiving a logic value of 1 as the input value. The switching element 319 may be turned on when receiving a logic value of 0 as the input value. For example, the switching element 319 may include a pull-up transistor capable of receiving an input value at a gate terminal. Examples of the switching element 319 as being the pull-up transistor are mainly described herein.

The pull-up transistor may have a gate and may be connected to an output line. Also, in the examples of FIGS. 3A to 3E, the gate terminal of the pull-up transistor may be connected to a pull-up line, and the pull-up line may be connected to the word line $WL_m$. However, examples are not limited thereto, and as described later with reference to FIG. 6A, the pull-up line may be connected to an input/word line driver separately from the word line $WL_m$, and the input/word line driver may apply an input value to the pull-up line. The pull-up transistor may output a signal corresponding to a multiplication result between an input value and a weight. One end of the pull-up transistor may be connected to the supply voltage $V_{DD}$, and the other end thereof may be connected to the output end $N_{out}$ of the memory cell 311. The output end $N_{out}$ of the memory cell 311 may be connected to a local bit line bar (or an LBLB), and the signal corresponding to the multiplication result may be output from the first local bit line LBLB in the examples of FIGS. 3A to 3E. The pull-up transistor may be a P-type metal-oxide-semiconductor (PMOS) transistor.

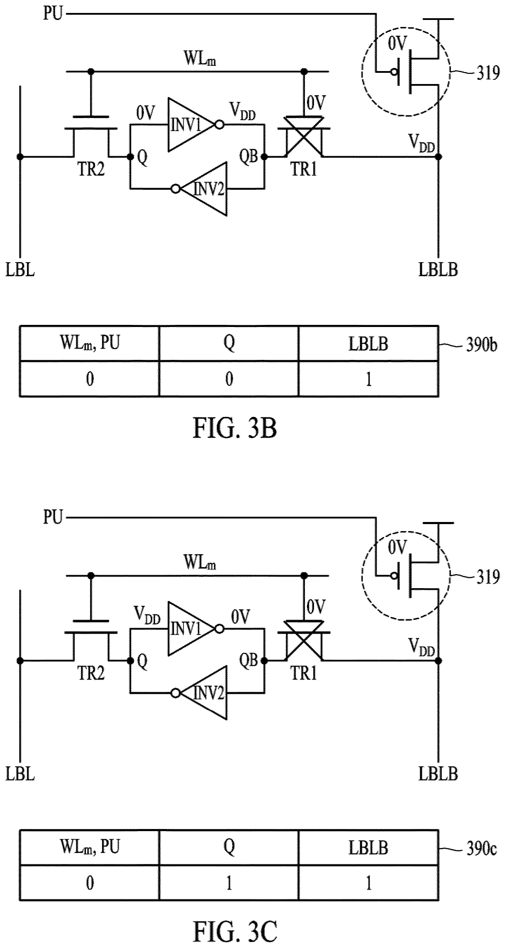

According to an embodiment, as an input (a same logic value) is applied to a gate of a pull-up transistor and to a gate of a cell transistor, the memory device (e.g., the multiplying cell 310) may output, to an output line, a logic value corresponding to a binary multiplication result of a binary weight set/stored in the memory cell 311 and the input. The logic value corresponding to the binary multiplication result may be determined as a NAND logic output. For example, the multiplying cell 310 may operate as illustrated in the truth table illustrated in FIG. 3A. The pull-up line PU may receive the same signal (e.g., an input value) as the word line $WL_m$. A signal corresponding to a weight appears at a node Q inside the memory cell 311. The multiplying cell 310 may receive the input value through the word line $WL_m$, and output a result (e.g., a NAND result) corresponding to a multiplication between a weight stored in the node Q and the input value to the first local bit line LBLB. Again, LBL indicates a local bit line, and LBLB indicates a local bit line bar. As illustrated in the truth table, an operation of the multiplying cell 310 may be a NAND operation. The examples of FIGS. 3B to 3E each illustrate a circuit state of the multiplying cell 310 for each respective proposition (row) in the logic table of FIG. 3A.

In the examples of FIGS. 3B and 3C, illustrated are cases 390b and 390c, respectively, in which the multiplying cell 310 receives an input value of 0 through the pull-up line PU and the word line $WL_m$. The pull-up transistor may provide the supply voltage $V_{DD}$ to the first local bit line LBLB. The supply voltage $V_{DD}$ may represent a logic value of 1, and a ground voltage (e.g., 0V) may represent a logic value of 0. The first transistor TR1 may be opened by the input value of 0 received through the word line $WL_m$. When the first transistor TR1 is opened, the node QB of the memory cell 311 may be disconnected from the first local bit line LBLB. Accordingly, when the input value received through the pull-up line PU and the word line $WL_m$ is 0, an output of the multiplying cell 310 may become independent of a weight that is set for (stored in) the nodes Q and QB. The multiplying cell 310 may output a logic value of 1 to the output end $N_{out}$ regardless of whether the weight set for the node Q is 0 or 1.

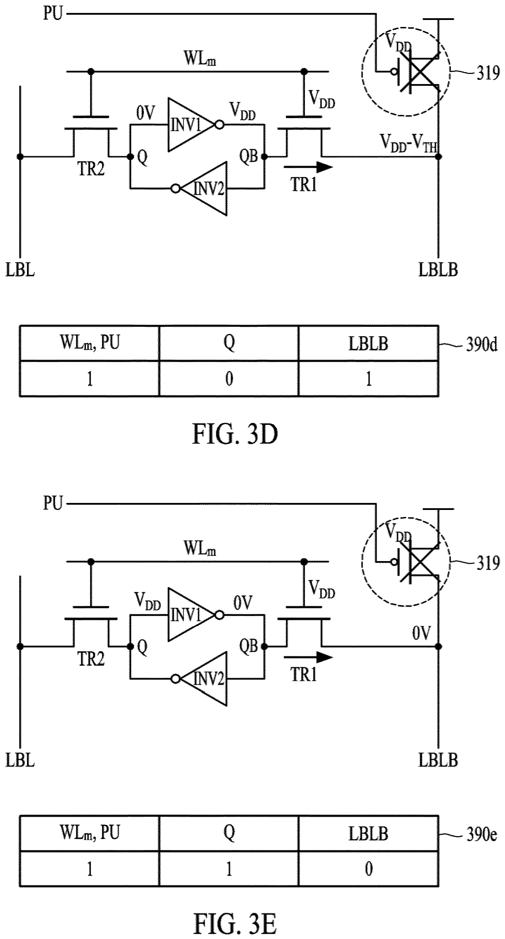

In the examples of FIGS. 3D and 3E, illustrated are respective cases 390d and 390e in which the multiplying cell 310 receives an input value of 1 through the pull-up line PU and the word line $WL_m$. The pull-up transistor may be opened by the input value of 1 received through the pull-up line PU. When the pull-up transistor is opened, the supply voltage $V_{DD}$ is disconnected from the first local bit line LBLB. Accordingly, when the input value received through the pull-up line PU is 1, an output of the multiplying cell 310 becomes independent of the supply voltage $V_{DD}$ but may depend on the weight that is set for the nodes Q and QB. The multiplying cell 310 may output a value corresponding to the node QB on the first local bit line LBLB. Referring to FIG. 3E, when the input value of the pull-up line PU and the word line $WL_m$ is 1 and the weight of the node Q is 1, a ground voltage (e.g., 0V) corresponding to a logic value of 0 (e.g., 0V) of the node QB may appear on the first local bit line LBLB. Referring to FIG. 3D, in the case 390d in which the input value of the pull-up line PU and the word line $WL_m$ is 1 and the weight of the node Q is 0, the multiplying cell 310 may drive a voltage of the first local bit line LBLB maximally to $V_{DD}-V_{TH}$. Although this state of $V_{DD}-V_{TH}$ may not completely correspond to the logic value of 1, it may be processed as substantially equivalent to the logic value of 1. For example, in most operations, the first local bit line LBLB may be pre-charged with the supply voltage $V_{DD}$. Since the word line $WL_m$ is turned on while the first local bit line LBLB is pre-charged with the supply voltage $V_{DD}$, the first local bit line LBLB may be maintained at the supply voltage $V_{DD}$ or a voltage close to the supply voltage $V_{DD}$. Accordingly, a digital logic circuit (e.g., an adder) connected subsequently may correctly recognize the logic value as 1 and operate normally.

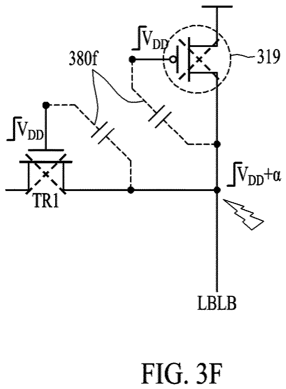

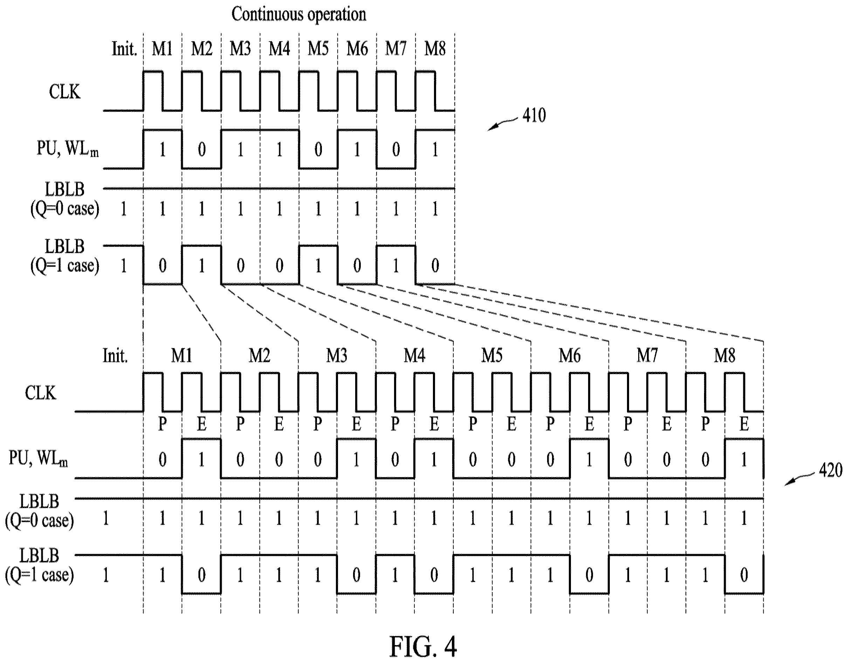

However, in the multiplying cell 310 operating as illustrated in FIG. 3D, a type of a bootstrapping circuit may be formed due to a parasitic capacitance 380f of the first transistor TR1 and the pull-up transistor, as illustrated in FIG. 3F. When the multiplying cell 310 repeats an operation as described above with reference to FIG. 3D, power leakage may occur. When power leakage occurs, an operation may be performed as described below with reference to FIG. 4.

For example, signals in an inverse relationship may appear in the second local bit line LBL and the first local bit line LBLB. An example in which the same logic value is applied to the pull-up line PU and the activated word line $WL_m$ is mainly described herein.

FIG. 4 illustrates examples of an operation of a multiplying cell according to one or more embodiments.

According to an embodiment, a memory device (e.g., the memory device 200 of FIG. 2) may select one operation from between a first operation 410 and a second operation 420 and perform the selected operation. Depending on which operation is selected, a multiplication result may be output every clock cycle or every two clock cycles. FIG. 4 is a timing diagram illustrating a timing for each operation in one multiplying cell of the memory device. The memory device may perform an operation by selecting and/or combining the first operation 410 and the second operation 420. However, examples are not limited thereto, and the memory device may be constructed to perform only one of the first operation 410 and the second operation 420. A multiplication may be performed every clock cycle in the first operation 410, and a multiplication may be performed every two clock cycles in the second operation 420. In the timing diagram, M1 indicates a first multiplication operation, M2 indicates a second multiplication operation, and M3 to M8 indicate third to eighth multiplication operations, respectively. In the example illustrated in FIG. 4, in an initial state (init.), there may be no input value received through a word line WL and it may therefore be 0 b default, and thus a local bit line LBLB may be driven to a supply voltage $V_{DD}$ by a pull-up transistor. In this state, the following operations may be performed.

The first operation 410 may be an operation of outputting a multiplication operation result every time (every clock/CLK cycle) according to a supplied input. The first operation 410 may include an operation of driving a voltage at an output end of the pull-up transistor to the supply voltage as a voltage (e.g., 0V) sufficiently lower than the supply voltage is applied through the word line WL in some of a series of multiplication operations. That is, the voltage at the output end may be initialized to the supply voltage. The multiplying cell of the memory device may receive an input signal (e.g., an input value) on which an operation is to be performed every clock cycle through the word line WL. The multiplying cell may output a multiplication operation result between the input value and a weight stored in a node Q.

For example, in a state of M1, when the input value received through the word line WL is 1 and the weight of node Q is 0, the multiplying cell may maintain the supply voltage $V_{DD}$ on a local bit line LBLB. This is because when there is no leakage current (or when a leakage current is less than or equal to a threshold value) a voltage of the local bit line LBLB may be maintained at the supply voltage $V_{DD}$ without being dropped. In a state of M2, the input value of the word line WL is 0, and thus the local bit line LBLB may be driven toward the supply voltage $V_{DD}$. Even when a slight leakage current occurs in the state of M1, the voltage of the local bit line LBLB may be restored due to the driving in the state of M2. When the input becomes 1 again in a state of M3, similar to the state of M1, the multiplying cell may maintain the supply voltage $V_{DD}$ on the local bit line LBLB. Thus, unless the leakage is large, the multiplying cell may substantially correctly output, as a voltage (e.g., 0 or $V_{DD}$) corresponding to a logic value, a result of a multiplication of all input bit values and weight bit values to the local bit line LBLB through an output end.

For example, the memory device may perform an operation for pre-charging on the output end of the pull-up transistor in response to either a case where a predetermined period has elapsed or a case where a multiplication operation using another memory cell is performed in each multiplying cell. During the operating time, if an input value of 0 is not received through the word line WL and through the pull-up line PL, and if a voltage is not driven to the supply voltage on the local bit line LBLB, the voltage of the local bit line LBLB may be gradually reduced by an amount of voltage that may be up to $V_{DD}$-$V_{TH}$. The memory device may periodically perform an initialization operation (e.g., an operation of applying a voltage of 0 to the word line WL) such that the voltage of an output end of a multiplier is maintained at the supply voltage.

The second operation 420 may be an operation of driving a voltage of the output end of the pull-up transistor to the supply voltage in a pre-charge phase P for each multiplication operation and performing a multiplication operation in an evaluation phase E (as opposed to every clock cycle as in the first operation 410). For example, in the second operation 420, a first clock cycle may be used for the pre-charge phase P and a next clock cycle may be used for the evaluation phase E. An operation in the evaluation phase E may be the same as the first operation 410. The memory device may permanently force the voltage of the word line WL to 0 in a corresponding clock cycle in the pre-charge phase P. That is, the memory device may drive, to the supply voltage $V_{DD}$, the voltage of the local bit line LBLB to which the output end of the multiplying cell is connected. Thereafter, the memory device may perform an operation by transmitting an input value to the word line WL in the evaluation phase E. The second operation 420 may be used in a structure in which a large leakage current occurs due to a circuit structure and layout or in a circuit using a clock cycle of a frequency slower than a threshold value.

The memory device may selectively determine and use an operation option in an advantageous manner according to a situation. For example, the memory device may select the first operation 410 or the second operation 420 of the memory device based on an operating frequency of the memory device or a leakage. The memory device may perform the second operation 420 when the operating frequency is less than a threshold frequency, and perform the first operation 410 when the operating frequency is greater than or equal to the threshold frequency. The memory device may perform the second operation 420 when the leakage is greater than a threshold value and perform the first operation 410 when the leakage is less than or equal to the threshold value. The memory device may further include a circuit for monitoring the foregoing operating frequency or leakage current, and a memory controller of the memory device, an input/word line driver, or an external processor may determine which of the operating modes is in effect.

FIG. 5 illustrates an example of a memory device in which multiplying cells are arranged in an array structure according to one or more embodiments.

According to an embodiment, a memory device (e.g., the memory device 200 of FIG. 2) may include a memory array in which multiplying cells 510 described above with reference to FIG. 3A are arranged. The multiplying cells 510 may be arranged along word lines $WL_0$ to $WL_{M-1}$ and may have respective output lines. An input/word line driver 520 may transmit an input value to the word lines $WL_0$ to $WL_{M-1}$. An adder 530 may be arranged for the output lines of a group/column of multiplying cells 510. The memory device having the memory array illustrated in FIG. 5 may also be referred to as an SRAM IMC macro circuit. As described above, the input value may be transmitted to each multiplying cell 510 through the word lines $WL_0$ to $WL_{M-1}$. A multiplying cell 510 may output a multiplication result between a weight stored therein and the input value to a local bit line LBLB. A plurality of local bit lines may be connected to the adder 530. The adder 530 may add multiplication results and transmit such an adding result to an accumulator, for example in an outputter 540. The accumulator of an outputter 540 may output a final MAC operation result by combining adding results for each bit position based on bit shifting.

In addition, the memory device may further include a global bit line (e.g., GBL and GBLB) and a switch SW for at least one of a read operation or a write operation on the weight of the memory cell through access to the memory cell of the multiplying cell 510. The global bit line (e.g., GBL and GBLB) may be connected to a first transistor and a second transistor of the multiplying cell 510 via the switch SW. GBLB indicates a global bit line bar (as in a crossbar construction). The global bit line (e.g., GBL and GBLB) may be connected to a read/write circuit 580. For example, the memory device may turn on switches SW disposed at both ends of a memory cell that is a target of a read operation or a write operation. The memory device may access a corresponding switched-on memory cell by activating a word line connected to the memory cell. The memory device may read a weight value recorded in the memory cell or may change and/or set the weight value of the memory cell through the read/write circuit 580 .

Hereinafter, a structure that may improve area efficiency (computation/storage per unit of chip area) as a plurality of memory cells is connected within one multiplying cell 510 to share one pull-up transistor will be described with reference to FIG. 6A.

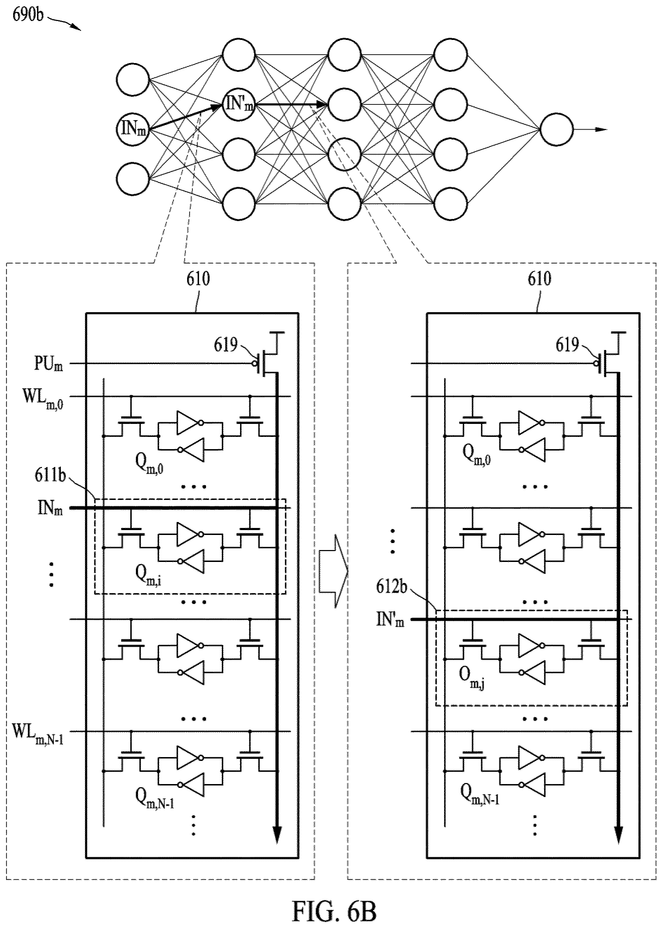

FIGS. 6A and 6B illustrate example structure in which memory cells share a pull-up transistor in a multiplying cell according to one or more embodiments.

According to an embodiment, a multiplying cell 610 may be implemented in a structure in which a plurality of memory cells 611 share the same multiplication circuit (i.e., store bits for a same multiplying cell 610). For example, at least one multiplying cell 610 may include memory cells 611 connected to the same pull-up transistor 619 of the multiplying cell 610. The pull-up transistor 619 may be connected to output ends of the respective memory cells 611 at the same node and on the same local bit line. FIG. 6A illustrates an example in which an input/word line driver 620 applies an m-th input to an i-th memory cell 611 among the memory cells 611 in the multiplying cell 610. In this example, i may be greater than or equal to 0 and less than or equal to N-1.

The input/word line driver 620 may select a memory cell 611 of a multiplying cell 610 to be used for a target multiplication operation from among the plurality of memory cells 611 of the multiplying cell 610. The input/word line driver 620 may include a decoding circuit The decoding circuit may decode an input value provided to the multiplying cell 610 from an input signal and a signal appointing/selecting the memory cell 611 among the memory cells 611 included in the multiplying cell 610 to be used for the target multiplication operation. For example, in the example of FIG. 6A, the signal appointing the memory cell 611 to be used for the target multiplication operation may indicate the i-th memory cell 611 (see signal i inputted to the input/word line driver 620). The memory device may activate a word line connected to a memory cell 611 having a weight corresponding to a target operation among the memory cells 611 included in one multiplying cell 610, and deactivate a word line connected to a remaining memory cell 611 among the memory cells 611. In some embodiments, in the multiplying cell 610, only one memory cell 611 may be activated for one multiplication operation; all others are deactivated. The input signal may be both permanently applied to a pull-up line $PU_m$, and may be temporarily applied only to the activated word line among word lines. The input/word line driver 620 may apply the same logic value to the pull-up line $PU_m$ and the activated word line (e.g., $WL_{m,i}$).

For example, the input/word line driver 620 may apply an m-th input value $IN_m$ to an m-th pull-up line $PU_m$ and an i-th word line $WL_{m,i}$ in the multiplying cell 610 in response to an m-th input. A remaining word line $WL_{m,k}$ may be deactivated. As illustrated in a timing diagram, the m-th multiplying cell 610 may output a multiplication result $P_{m,i}$ between the input value received through the i-th word line and a weight of the i-th memory cell 611 through a shared pull-up transistor 619 on a local bit line. That is, the multiplying cell 610 may output the multiplication result $P_{m,i}$ between the m-th input value $IN_m$ and the i-th weight $Q_{m,i}$.

FIG. 6A illustrate examples in which the input value $IN_m$ is applied to the i-th word line $WL_{m,i}$ and the m-th pull-up line $PU_m$ and an i-th weight $Q_{m,i}$ is 1 or 0. In an example in which the i-th weight $Q_{m,i}$ is 1, the multiplication result $P_{m,i}$ may represent 0 as illustrated in FIG. 3E in a cycle 601 in which the input value $IN_m$ is 1, and may represent 1 as illustrated in FIG.

3C in a cycle 602 in which the input value $IN_m$ is 0. In an example in which the i-th weight $Q_{m,i}$ is 0, the multiplication result $P_{m,i}$ may represent 1 in all the cycles 601 and 602 as illustrated in FIGS. 3B and 3D.

For example, the truth table of FIG. 3A assumes that the same input value is applied to a memory cell and a pull-up transistor connected to one word line. However, in the example of FIG. 6A, logic values of signals to be applied respectively to a remaining deactivated word line $WL_{m,k}$ and a pull-up transistor may be independent of each other and different from each other, and thus the truth table of FIG. 3A may not be applicable to memory cells connected to the remaining word line $WL_{m,k}$. For example, a first transistor and a second transistor may be turned off (e.g., by switches SW) in a memory cell connected to the remaining deactivated word line $WL_{m,k}$, and thus a node for which a weight of the corresponding memory cell is set may be disconnected from an output end. A weight set for the memory cells connected to the remaining deactivated word line $WL_{m,k}$ may become independent of the output end, and the memory cells connected to the remaining word line $WL_{m,k}$ may be excluded from forming an output. Accordingly, in the structure illustrated in FIG. 6A, a multiplying cell may output only a signal corresponding to a multiplication result by a memory cell connected to the activated i-th word line $WL_{m,i}$ and the pull-up transistor 619 from the output end. As the number of memory cells 611 sharing the same pull-up transistor 619 in one multiplying cell 610 increases, area efficiency may be improved.

According to an embodiment, the memory device may selectively activate a memory cell corresponding to each operation while sequentially performing a plurality of operations. That is, memory cells in a multiplying cell may be activated sequentially for respectively corresponding operations. When M multiplying cells are arranged on one output line and each of the multiplying cells includes N memory cells, a total number of memory cells may be M×N. For each operation, one memory cell may be selected from each of the M multiplying cells, and thus the memory device may select M memory cells from among the M×N memory cells. For a first operation among a plurality of operations, the memory device may select a first memory cell from among a plurality of memory cells (for each of the M multiplying cells) and output a signal corresponding to a multiplication result through the same pull-up transistor 619. For a second operation among the plurality of operations, the memory device may select a second memory cell among the plurality of memory cells and output a signal corresponding to a multiplication result through the same pull-up transistor 619.

For example, referring to FIG. 6B, the memory device may divide an operation of a large neural network 690b into a plurality of operations and execute the operations. Weights of the neural network 690b respectively corresponding to the operations may be distributed and set in a plurality of memory cells in a multiplying cell (and may do so for multiple multiplying cells). When performing a first operation among such neural network operations, the memory device may, for each implicated multiplying cell 610, activate a first memory cell 611b in which a first weight for the first operation is set/stored. For the implicated multiplying cells 610, remaining memory cells in each multiplying cell 610 may be deactivated. When performing a second operation among the neural network operations after performing the first operation, for each of the multiplying cells 610, the memory device may activate the second memory cells 612b which are storing a second weight for the second operation. Remaining memory cells, including the first memory cell 611b, may be deactivated.

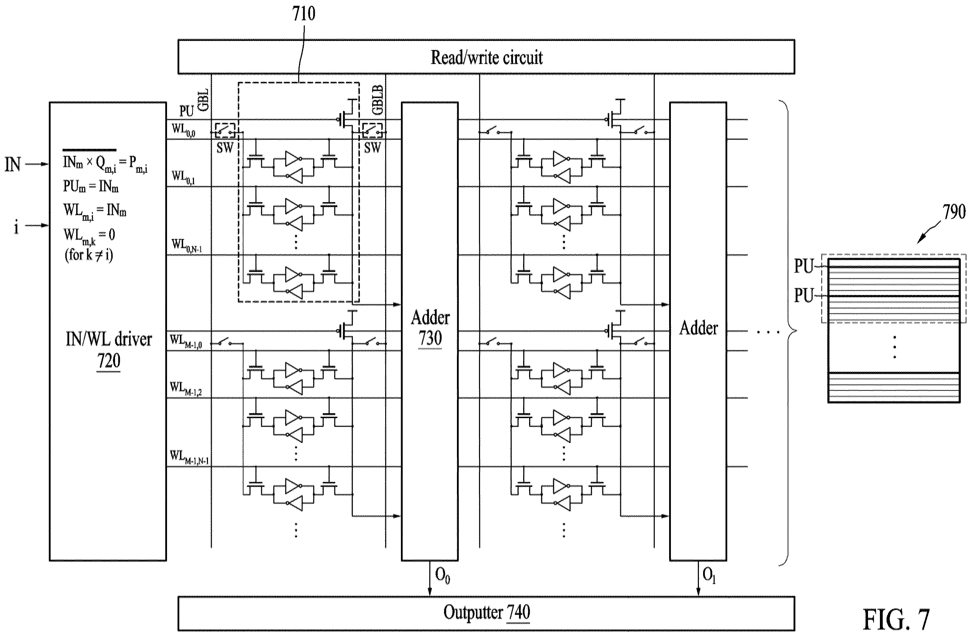

FIG. 6B illustrates an example in which the first operation corresponding to a node in the neural network 690b and the second operation corresponding to a subsequent node connected to that node are performed using different memory cells 611b and 612b in the same multiplying cell 610. In this example, the first operation may be an operation of multiplying, by a first weight $Q_{m,i}$, one input value $IN_m$ among a plurality of input values IN propagated to a corresponding node, and the second operation may be an operation of multiplying, by a second weight $Q_{m,j}$, one input value $IN'_m$ among a plurality input values IN' propagated to a subsequent node. However, examples are not limited thereto, and memory cells in the same multiplying cell may have a weight for an operation in different parts of the same task (e.g., the same neural network operation) or may have a weight for different tasks (e.g., face recognition and object recognition). Hereinafter, an array structure for selective usage of memory cells will be described with reference to FIG. 7.

FIG. 7 illustrates an example of a memory device in which the multiplying cell of FIG. 6A is arranged in an array structure according to one or more embodiments.

According to an embodiment, a memory device may include multiplying cells including a multiplying cell 710. For example, the multiplying cells may be arranged in an array structure. The multiplying cells may be arranged along a plurality of output lines and a plurality of word lines. As illustrated in FIG. 7, an input/word line driver 720 may select a memory cell (e.g., a memory cell corresponding to i) in which a weight $Q_{m,i}$ corresponding to a target task is set among a plurality of memory cells included in the multiplying cell 710. The input/word line driver 720 may transmit an input value $IN_m$ to the memory cell in which the weight $Q_{m,i}$ corresponding to the target task is set individually for the multiplying cells. Accordingly, when performing various tasks over multiple cycles, the memory device may set in advance a weight $Q_{m,i}$ required in each cycle in memory cells in each of the multiplying cells. When the target task is changed, the memory device may select a memory cell having a set weight $Q_{m,i}$ corresponding to the changed target task from among the memory cells and perform a multiplication operation, without loading the weight corresponding to the changed task from the outside the memory device.

For example, multiplying cells connected to the same word line may receive the same input value $IN_m$. Each of the multiplying cells may perform a multiplication operation in parallel with each of the other multiplying cells. The memory device may add outputs of multiplying cells connected to the same column line (e.g., the same output line) among the multiplying cells, in the same adder 730. One multiplying cell and another multiplying cell may output their multiplication results in parallel with each other. In one multiplying cell (e.g., the multiplying cell 710), a multiplication operation based on one memory cell may be performed. That is, for example, when each multiplying cell 710 includes N memory cells, the input/word line driver 720 may select one memory cell from among the N memory cells every cycle. When M multiplying cells are connected to an output line, M multiplication operations may be performed in parallel. When there are T output lines, M×T multiplication operations may be performed in parallel in the memory array of the memory device. Since results of the M multiplication operations connected to the same output line are added, an outputter 740 may generate T accumulated output values.

In the memory device illustrated in FIG. 7, as the number of memory cells included in each respective multiplying cell 710 increases, the number of transistors required for one multiplication operation by one multiplying cell may decrease. For example, when the multiplying cell 710 includes four memory cells, one multiplication operation may be construed as being implemented by 7.25 transistors. This is because each memory cell includes six transistors, there is one transistor for pull-up, and each of two switches for a global bit line includes two transistors, and $(6\times4+5) = 29$ transistors are shared by the four memory cells. For example, when the multiplying cell 710 includes eight memory cells, one multiplication operation may be construed as being implemented by 6.625 transistors. Similarly, this is because $(6\times8+5) = 53$ transistors may be shared by the eight memory cells. When the multiplying cell 710 includes 16 memory cells, one multiplication operation may be construed as being implemented by 6.3125 transistors. Similarly, this is because $(6\times16+5) = 101$ transistors may be shared by the 16 memory cells. Since a plurality of multiplying cells arranged in the form of an array along a word line may be driven by one input/word line driver 720, area overhead may also be reduced. Thus, memory devices according to one or more embodiments may have an area reduction effect compared to other IMC memory devices.

As illustrated on the right side of FIG. 7, a pattern of one pull-up line PU and a plurality of word lines $WL_{0,0}$ to $WL_{0,N-1}$ may appear repeatedly in a layout 790.

FIG. 8 illustrates an example of outputting a multiplication result from a multiplying cell through a pair of local bit lines according to one or more embodiments.

According to an embodiment, a multiplying cell 810 may be connected to a pair of local bit lines. The multiplying cell 810 may output a multiplication result based on a first memory cell 811 (selected among a plurality of memory cells of the multiplying cell 810) to a first local bit line 850R, and output a multiplication result based on a second memory cell 812 to a second local bit line 850R. In the example of FIG. 8 , the first memory cell 811 is illustrated as a memory cell in which a weight $Q_{m,i}$ is set/stored, and the second memory cell 812 is illustrated as a memory cell in which a weight $Q_{m,j}$ is set/stored. For example, while the first local bit line 850R is illustrated as an output end in the example of FIG. 3A, a multiplication result may be output from both the first local bit line 850R and the second local bit line 850L in the example of FIG. 8. Here, from the first local bit line 850R, as a result corresponding to the multiplication operation, a NAND result between an input value $IN_m$ and the weight $Q_{m,i}$ is output, as described above with reference to FIGS. 1 through 7. However, from the second local bit line 850L, as a result corresponding to the multiplication operation, a NAND result between the input value $IN_m$ and an inverse value of the weight $Q_{m,j}$ may be output. The memory device may set/store, for the first memory cell 811, a value corresponding to a weight to be computed, and may set/store, for the second memory cell 812, an inverse value obtained by inverting the weight to be computed.

The memory device may include a first pull-up transistor 819-R for outputting the multiplication result to the first local bit line 850R (e.g., a first output line) and may also include a second pull-up transistor 819-L for outputting the multiplication result to the second local bit line 850L (e.g., a second output line). Accordingly, the first memory cell 811 connected to the first local bit line 850R may have a value corresponding to a weight. The second memory cell 812 connected to the second local bit line 850L may have an inverse value of the weight. The memory device may include a plurality of memory cells connected to the first output line and the second output line.

In an adder, the multiplication result output through the first local bit line 850R of the first memory cell 811 may be added to the multiplication result output through the second local bit line 850L of the second memory cell 812. That is, even in the same multiplying cell, multiplication results of memory cells connected to different local bit lines may be added in the adder. A structure illustrated in FIG. 8 may be construed that two column lines are merged into one multiplying cell 810. For example, the multiplying cell 810 illustrated in FIG. 8 may include N memory cells (delineated by dashed lines through the multiplying cell 810). In this example, a multiplication operation may be performed in each of a first memory cell 811 (e.g., an i-th memory cell) among N/2 memory cells connected to the first local bit line 850R and a second memory cell 812 (e.g., a j-th memory cell) among N/2 memory cells connected to the second local bit line 850L. In this example, N may be a multiple of 2. One first word line RWL and one second word line LWL may be connected to each respective memory cell. The input/word line driver 820 may activate one word line $RWL_{m,i}$ among first word lines $RWL_{m,0}$ to $RWL_{m,N-1}$, and deactivate remaining word lines $RWL_{m,k}$. Also, the input/word line driver 820 may activate one word line $LWL_{m,j}$ among second word lines $LWL_{m,0}$ to $LWL_{m,N-1}$, and deactivate remaining word lines $LWL_{m,p}$. Here, i, j, k, and p may each be an integer greater than or equal to 0, and i may be different from k, and p may be different from j.

For example, the memory device may output a multiplication operation based on a memory cell having one of even-numbered index/location of weights in the multiplying cell 810 to the first local bit line 850R, and output a multiplication operation based on a memory cell having one of odd-numbered index/location of weights to the second local bit line 850L. However, a method of setting a weight is not limited to the foregoing example. Although the number of memory cells connected to the first local bit line 850R and the number of memory cells connected to the second local bit line 850L are described herein as being the same in one multiplying cell 810 for a symmetrical structure, examples are not limited thereto. For example, depending on design, the number of memory cells connected to each local bit line may vary.

According to an embodiment, the memory device may simultaneously perform multiplications on a first weight $Q_{m,i}$ and a second weight $Q_{m,j}$ with respect to the same input value $IN_m$ within one multiplying cell 810. The input/word line driver 820 may apply a logic value of the input value $IN_m$ to a pull-up line $PU_m$, a second word line $LWL_{m,j}$, and a first word line $RWL_{m,i}$, all at once. The input/word line driver 820 may apply a logic value of 0 to all remaining word lines. A first multiplication result RP and a second multiplication result LP may be simultaneously output respectively from the first local bit line 850R and the second local bit line 850L. The structure illustrated in FIG. 8 is a symmetrical structure and may thus be advantageous in terms of layout.

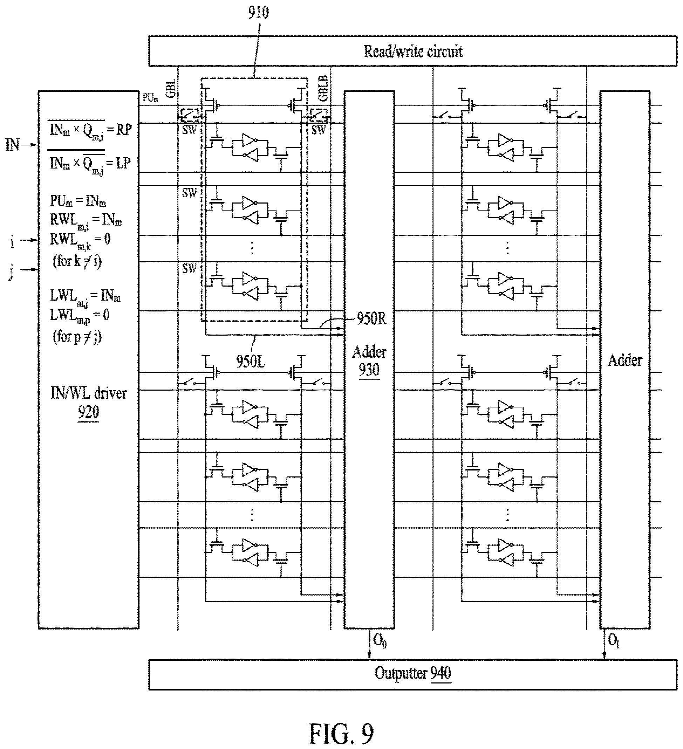

FIG. 9 illustrates an example of a memory device in which the multiplying cell of FIG. 8 is arranged in an array structure according to one or more embodiments.

A multiplying cell 910 illustrated in FIG. 9 may be arranged as in the array structure illustrated in FIG. 7. Two word lines RWL and LWL may be used for each multiplying cell 910. In addition, each multiplying cell 910 may simultaneously output two multiplication results through two local bit lines LBL and LBLB. For example, a first local bit line 950R and a second local bit line 950L of FIG. 9 may correspond to LBLB and LBL, respectively. An input/word line driver 920 may select, for each multiplying cell 910, a first memory cell corresponding to the first local bit line 950R and a second memory cell corresponding to the second local bit line 950L, and allow parallel multiplication operations to be performed individually. For example, even when the memory device outputs a multiplication result obtained using one memory cell to the first local bit line 950R in a cycle, it may not be permanently fixed to output the multiplication result of the memory cell to the first local bit line 950R. The memory device may operate to output the multiplication result obtained using the memory cell to the second local bit line 950L in another cycle. In this case, the memory device may set/store an inverted weight to the memory cell.

The multiplication results of the local bit lines may be individually transmitted to an adder 930. For example, as illustrated in FIG. 9, the first memory cell and the second memory cell of the multiplying cell 910 may be mapped to the first local bit line 950R, and a third memory cell and a fourth memory cell thereof may be mapped to the second local bit line 950L. The memory device may add a multiplication result based on the first memory cell and a multiplication result based on the third memory cell or the fourth memory cell, in the adder 930. Similarly, the memory device may add a multiplication result based on the second memory cell and a multiplication result based on the third memory cell or the fourth memory cell, in the adder 930. As described above with reference to FIG. 8, even for memory cells arranged in the same multiplying cell 910, multiplication results based on memory cells corresponding to different local bit lines (e.g., odd/even) may be performed in parallel, and may be added in the adder 930. An outputter 940 may accumulate outputs of the adder 930 connected to respective output lines and may output a final multiplication result.

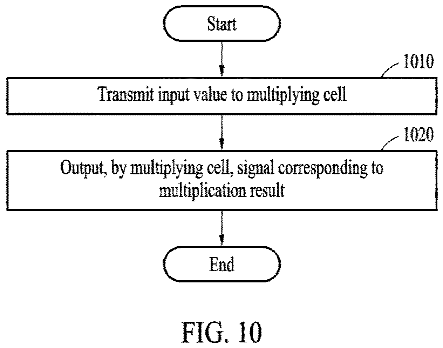

FIG. 10 illustrates an example of an operation method of a multiplying cell according to one or more embodiments.

In operation 1010, a memory device may transmit an input value to a multiplying cell. For example, a memory cell may receive the input value through a word line. As described above, the memory cell may have two inverters connected (paired ends) in opposite directions and two transistors connected to the paired ends of the two inverters, respectively. A pull-up transistor connected to an output end of the memory cell may receive the input value at a gate terminal.

In operation 1020, the multiplying cell of the memory device may output a signal corresponding to a multiplication result. For example, the memory device may output a signal corresponding to the multiplication result between the input value and a weight stored in the memory cell from an output end of the pull-up transistor. According to the truth table illustrated in FIG. 3A, the signal corresponding to the multiplication result (e.g., a NAND result) may be output from the output end of the pull-up transistor and the memory cell.

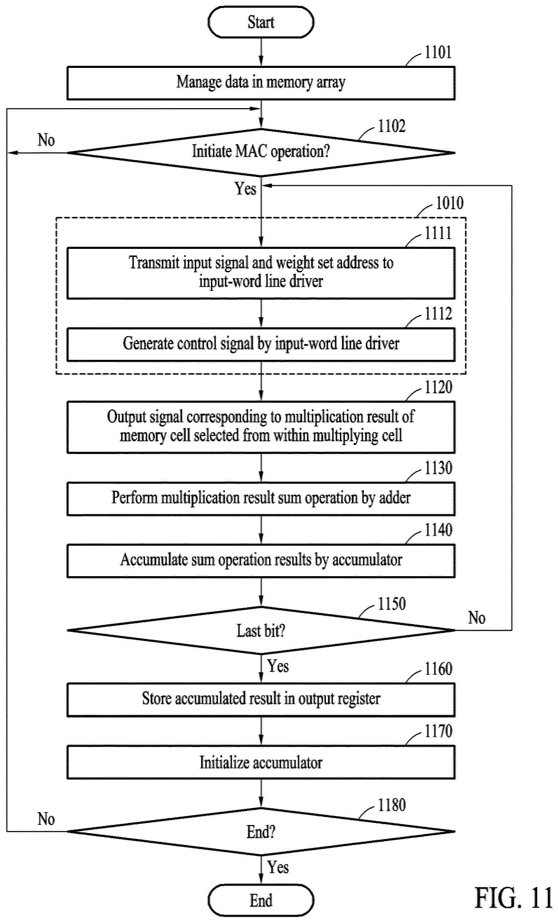

FIG. 11 illustrates an example of an operation method of a memory device according to one or more embodiments.

In operation 1101, a memory device may manage data in a memory array. For example, the memory device may set/store a weight (or any data to serve as an operand for an IMC operation such as a MAC operation) for each memory cell of the memory array, using a read/write circuit. A processor external to the memory device may instruct the memory device with data to be written and an address of the memory cell for which the weight is to be set/stored.

In operation 1102, the memory device may determine whether to initiate a MAC operation. For example, when receiving an input value that is a target or operand of the MAC operation, the memory device may initiate the MAC operation.

Subsequently, in operation 1010, the memory device may transmit the input value to a multiplying cell. For example, in operation 1111, the memory device may transmit an input signal and a weight set address to an input/word line driver. The external processor may also transmit, to the memory device, the input signal and the weight set address (e.g., a signal indicating an i-th memory cell among memory cells included in the multiplying cell). In operation 1112, the input/word line driver may generate a control signal. For example, the input/word line driver may decode the input signal and the weight set address, and apply a logic value equal to the input value to a pull-up line $PU_m$ and a word line $WL_{m,i}$. The input/word line driver may apply a logic value of 0 to remaining word lines.

In operation 1120, the memory device may output a signal corresponding to a multiplication result of a memory cell selected from within the multiplying cell. For example, each multiplying cell may output a signal (e.g., a NAND result value) corresponding to a multiplication result between an input value $IN_m$ and a weight $Q_{m,i}$ of the selected memory cell to a local bit line. Outputs of a plurality of multiplying cells connected to the same output line may be transmitted to an adder of the corresponding output line.

In operation 1130, the adder may perform a sum operation on multiplication results. As described above, the adder may receive a NAND result and may add an inverse value obtained by inverting the NAND result. The adder may transmit the added multiplication result values to an accumulator.

In operation 1140, the accumulator may accumulate a result of adding the multiplication results. As described later, in the case of a multi-bit input value, the accumulator may perform bit shifting according to a corresponding bit position and accumulate a multiplication result for a subsequent bit position.

In operation 1150, the memory device may determine whether the input value on which the multiplication operation is performed is a last bit. For example, when performing an operation on the last bit, the memory device may transmit an output of the accumulator to an output register. In the case of a single-bit input value, the accumulation may not be needed, and thus the accumulator may bypass the multiplication result to the output register. When a current input bit value is not the last bit, the memory device may perform the same operation on an input bit value of the subsequent bit position. When the multiplication result is output from the adder, the memory device may perform bit shifting on a previously stored accumulation result through the accumulator, add it up to the current multiplication result, and store a corresponding result in the accumulator again to accumulate the result.

In operation 1160, the memory device may store the accumulated result in the output register. For example, when receiving an input signal corresponding to the last bit of a single bit or multiple bits, the memory device may store, in the output register, a result of an operation of the accumulator for the input signal.

In operation 1170, the memory device may initialize the accumulator and at operation 1180 the process may end when the MAC operation is completed.

According to an embodiment, the memory device may have 30% or higher improved and/or reduced total number of transistors required for implementing a multiplication function, compared to a device embodying a 128Kb crossbar array structure with 10 or 12 transistors.

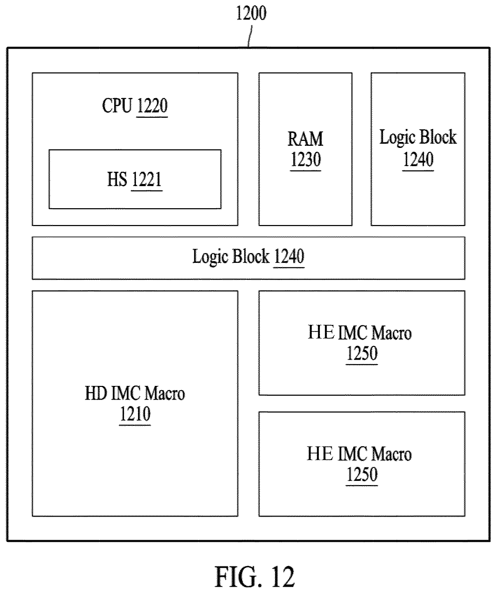

FIG. 12 illustrates an example implementation of a multiplying cell according to one or more embodiments.

According to an embodiment, an electronic device 1200 may include a high-density (HD) IMC macro 1210, a central processing unit (CPU) 1220, a random-access memory (RAM) 1230, a logic block 1240, and a high-efficiency (HE) IMC macro 1250.

The HD IMC macro 1210 may be a memory macro unit in which multiplying cells described above with reference to FIGS. 1 to 11 are arranged. The HD IMC macro 1210 may have a high memory density and a high memory capacity. The HD IMC macro 1210 may have a structure in which the multiplying cells described above are arranged in the form of a crossbar. A plurality of memory cells may be integrated in a multiplying cell, and thus the number of transistors required to manufacture the memory macro unit may be reduced.

The CPU 1220 may include a high-speed (HS) IMC macro 1221. The HS IMC macro 1221 may have a high throughput and operating speed and may represent a cell structure of a register file type.

The RAM 1230 may include a memory to be used as a system memory.

The logic block 1240 may include a logic circuit to be used for various logic operations.

The HE IMC macro 1250 may have a high energy efficiency and a low supply voltage operation.

According to an embodiment, the electronic device 1200 may be implemented as a dedicated hardware accelerator for an artificial intelligence (AI) algorithm (e.g., face recognition).

While embodiments are described herein as operating on neural network data such as weight data and input data inputted to a neural network, the embodiments of memory devices described herein are not limited to such applications. The IMC memory device features described herein can be used with any type of stored data or input data.

The computing apparatuses, the electronic devices, the processors, the memories, the image sensors, the displays, the information output system and hardware, the storage devices, and other apparatuses, devices, units, modules, and components described herein with respect to FIGS. 1-12 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a fieldprogrammable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-12 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the disclosure is defined by the claims.

**Claims**

1. A memory device, comprising:
   a multiplying cell (210, 310) comprising:

   a memory cell (311) in which a value is stored, wherein the memory cell (311) comprises a pair of inverters (INV1, INV2) comprising

   a first inverter (INV1) and a second inverter (INV2), each inverter comprising an input and an output, wherein the input of the first inverter is connected to the output of the second inverter at a first end of the pair of inverters, and wherein the output of the first inverter is connected to the input of the second inverter at a second end of the pair of inverters,
   a first transistor (TR1) connected to the first end (QB) of the pair of inverters, and
   a second transistor (TR2) connected to the second end (Q) of the pair of inverters; and
   a switching element (319) configured as a pull-up transistor and connected to an output end ($N_{out}$) of the memory cell (311), the pull-up transistor (319) configured to select one operation from between a first operation and a second operation and perform the selected operation, and to perform switching in response to an input value and output a signal corresponding to a multiplication result between the input value and the stored value,

   wherein the first operation comprises driving a voltage at an output end of the pull-up transistor (319) to a supply voltage in response to a voltage less than the supply voltage being applied through a word line ($WL_m$) in some multiplication operations in a series of multiplication operations, and outputting each time a multiplication operation result according to an input supplied to the memory device (100, 200), and
   wherein the second operation comprises driving a voltage at the output end of the pull-up transistor (319) to the supply voltage in a pre-charge phase for each multiplication operation, and performing a multiplication operation in an evaluation phase.

2. The memory device of claim 1, wherein the switching element (319) is configured to, when connected between a supply voltage and the output end of the memory cell (311):

   be turned off in response to a logic value of one being received as the input value; and
   be turned on in response to a logic value of zero being received as the input value, and/or
   wherein the pull-up transistor is configured to receive the input value at a gate terminal, wherein the first transistor (TR1) and the second transistor (TR2) are each an N-type metal-oxide-semiconductor, NMOS, transistor, and wherein the pull-up transistor (319) is a P-type metal-oxide-semiconductor, PMOS, transistor.

3. The memory device of claim 1 or 2, wherein the pull-up transistor is configured to receive the input value at a gate terminal, and
   wherein the memory device (100, 200) is further configured to select the one operation from between the first operation and the second operation based on either an operating frequency of the memory device (100, 200) or a leakage.

4. The memory device of one of claims 1 to 3, further comprising one or more of:

   an adder (230) connected to an output end of the multiplying cell (210, 310) and configured to add an inverse value of a signal output from the multiplying cell (210, 310), and

a global bit line and switch for a read operation or a write operation on the weight of the memory cell (311) through access to the memory cell (311) of the multiplying cell (210, 310).

5. The memory device of one of claims 1 to 4, wherein the multiplying cell (210, 310) comprises memory cells connected to the same pull-up transistor, and the memory device (100, 200) further comprises an input/word line driver (220) configured to select, from among the memory cells, a memory cell (311) to be used for a target multiplication operation, and
wherein the input/word line driver (220) comprises a decoding circuit configured to decode an input value provided to the multiplying cell (210, 310) from an input signal and from a signal designating the memory cell (311) to be used for the target multiplication operation.

6. The memory device of one of claims 1 to 5, wherein the multiplying cell (210, 310) comprises memory cells connected to the same pull-up transistor, and the memory device (100, 200) is further configured to perform one or more of:

   activating a word line connected to a memory cell (311) storing a value corresponding to a target operation among memory cells comprised in one multiplication cell, and deactivating a word line connected to a memory cell (311), among the memory cells, other than the memory cell (311) of the activated word line,
   selecting a first memory cell from among the memory cells for a first operation among a plurality of operations and outputting a signal corresponding to a multiplication result through the same pull-up transistor, and
   selecting a second memory cell from among the memory cells for a second operation among the plurality of operations and outputting a signal corresponding to a multiplication result through the same pull-up transistor.

7. The memory device of one of claims 1 to 6, further comprising:

   multiplying cells including the multiplying cell (210, 310), and
   configured to:

      perform a multiplication operation in each of the multiplying cells in parallel with other multiplying cells; and
      add, in the same adder, outputs of multiplying cells connected to the same column line among the plurality of multiplying cells, and

   further configured to, when receiving an input signal corresponding to a last bit of a single bit or multiple bits, store an accumulator operation result for the input signal in an output register.

8. The memory device of one of claims 1 to 7, wherein the multiplying cell (210, 310) is connected to a pair of local bit lines,

   wherein a first memory cell among memory cells comprised in the multiplying cell (210, 310) is connected to a first local bit line, and
   a second memory cell among the plurality of memory cells is connected to a second local bit line,
   wherein the first memory cell connected to the first local bit line has a value corresponding to a weight of a neural network, and
   the second memory cell connected to the second local bit line has an inverse value of the weight.

9. The memory device of one of claims 1 to 8, further comprising one or more of:

   an accumulator (241) configured to store an output of an adder (230) configured to add multiplication results of the multiplying cell (210, 310), and accumulate results of the adding,
   an output register configured to store a final multiplication operation result output from the accumulator (241), and
   a memory controller (290) configured to control the multiplying cell (210, 310), an input/word line driver (220), a read/write circuit (280), an adder, an accumulator, and an output register (242).

10. The memory device of one of claims 1 to 9, further configured to, in response to either a preset period having elapsed or a multiplication operation using another memory cell being performed in each multiplying cell (210, 310), perform an operation for a pre-charge on an output end of a pull-up transistor.

11. The memory device of claim 3, wherein:

   the gate of the pull-up transistor (319) is connected to an output line (LBLB);

the first transistor (TR1) is configured as a cell transistor having a gate and connected to the first end of the pair of inverters (INV1, INV2) and to the output line (LBLB); and

in response to an input having the same logic value being applied to the gate of the pull-up transistor (319) and the gate of the cell transistor (TR1), configured to output, to the output line (LBLB), a logic value corresponding to a binary multiplication result between the input and a binary value stored in the memory cell (210, 310).

12. The memory device of claim 11, wherein the logic value corresponding to the binary multiplication result is a NAND result,

wherein the pull-up transistor (319) is a P-type metal-oxide-semiconductor, PMOS, transistor, and the cell transistor is an N-type metal-oxide-semiconductor, NMOS, transistor, or

wherein the memory cell (210, 310) is one of multiple memory cells connected to the output line (LBLB).

13. The memory device of claim 11 or 12, wherein the multiplication result is either output every clock cycle, or only every two clock cycles.

14. The memory device of one of claims 11 to 13, wherein the cell transistor is a first cell transistor, and the memory cell further comprises a second cell transistor having a gate and connected to the second end of the pair of inverters, wherein an input having the same logic value is applied to the gate of the second cell transistor, or

wherein the output line is a first output line (LBLB) further comprising a second output line (LBL), wherein the cell transistor is a first cell transistor, and the memory cell further comprises a second cell transistor having a gate and connected to the other end of the pair of inverters and to the second output line, wherein the pull-up transistor is a first pull-up transistor, and wherein the memory device (100, 200) further comprises a second pull-up transistor connected to the second output line, and wherein the memory cell is one of multiple memory cells connected to the first output line and the second output line.

15. A method of operating a memory device (100, 200), the method comprising:

receiving an input value through a word line ($WL_m$) by a memory cell (311) comprising two inverters (INV1, INV2) connected to each other in opposite directions relative to each other, and two transistors (TR1, TR2) connected to both ends of the two inverters;

receiving the input value at a gate terminal by a pull-up transistor (319) connected to an output end of the memory cell (311);

selecting, by the pull-up transistor (319), one operation from between a first operation and a second operation and performing the selected operation, and switching in response to an input value and output a signal corresponding to a multiplication result between the input value and the stored value; and

outputting, from an output end of the pull-up transistor (319), a signal corresponding to a multiplication result between the input value and a weight stored in the memory cell (311),

wherein the first operation comprises driving a voltage at an output end of the pull-up transistor (319) to a supply voltage in response to a voltage less than the supply voltage being applied through a word line ($WL_m$) in some multiplication operations in a series of multiplication operations, and outputting each time a multiplication operation result according to an input supplied to the memory device (100, 200), and

wherein the second operation comprises driving a voltage at the output end of the pull-up transistor (319) to the supply voltage in a pre-charge phase for each multiplication operation, and performing a multiplication operation in an evaluation phase.

**Patentansprüche**

1. Speichervorrichtung, umfassend:
eine Multiplikationszelle (210, 310) umfassend:

eine Speicherzelle (311), in der ein Wert gespeichert ist, wobei die Speicherzelle (311) ein Inverterpaar (INV1, INV2) umfasst, umfassend:

einen ersten Inverter (INV1) und einen zweiten Inverter (INV2), jeder Inverter umfassend einen Eingang und einen Ausgang, wobei der Eingang des ersten Inverters mit dem Ausgang des zweiten Inverters an einem ersten Ende des Inverterpaares verbunden ist, und wobei der Ausgang des ersten Inverters mit dem Eingang des zweiten Inverters an einem zweiten Ende des Inverterpaares verbunden ist,
einen ersten Transistor (TR1), der mit dem ersten Ende (QB) des Inverterpaares verbunden ist, und
einen zweiten Transistor (TR2), der mit dem zweiten Ende (Q) des Inverterpaares verbunden ist; und
ein Schaltelement (319) konfiguriert als ein Pull-up-Transistor und verbunden mit einem Ausgangsende (Nout) der Speicherzelle (311), wobei der Pull-up-Transistor (319) konfiguriert ist, zum Auswählen einer Operation aus einer ersten Operation und einer zweiten Operation und zum Ausführen der ausgewählten Operation, und zum Ausführen von Schaltvorgängen in Reaktion auf einen Eingangswert und zum Ausgeben eines Signals entsprechend einem Multiplikationsergebnis zwischen dem Eingangswert und dem gespeicherten Wert,

wobei die erste Operation umfasst das Steuern einer Spannung an einer Ausgabeseite des Pull-up-Transistors (319) auf eine Versorgungsspannung in Reaktion auf eine Spannung, die geringer ist als die Versorgungsspannung, die durch eine Wortleitung (WLm) in einigen Multiplikationsoperationen in einer Reihe von Multiplikationsoperationen angelegt wird, und das Ausgeben jedes Mal eines Multiplikationsoperationsergebnisses gemäß einer Eingabe, die der Speichervorrichtung (100, 200) zugeführt wird, und
wobei die zweite Operation umfasst das Steuern einer Spannung an der Ausgangsseite des Pull-up-Transistors (319) auf die Versorgungsspannung in einer Vorladephase für jede Multiplikationsoperation und Ausführen einer Multiplikationsoperation in einer Auswertungsphase.

2. Speichervorrichtung nach Anspruch 1, wobei das Schaltelement (319) konfiguriert ist, um, wenn es zwischen einer Versorgungsspannung und der Ausgangsseite der Speicherzelle (311) angeschlossen ist:

ausgeschaltet zu werden als Reaktion auf einen Logikwert von Eins, der als Eingangswert empfangen wird; und eingeschaltet zu werden als Reaktion auf einen Logikwert von Null, der als Eingangswert empfangen wird, und/oder
wobei der Pull-up-Transistor konfiguriert ist, zum Empfangen des Eingangswertes an einem Gate-Anschluss, wobei der erste Transistor (TR1) und der zweite Transistor (TR2) jeweils ein N-Typ-Metalloxid-Halbleiter, NMOS-Transistor, sind, und wobei der Pull-up-Transistor (319) ein P-Typ-Metalloxid-Halbleiter, PMOS-Transistor, ist.

3. Speichervorrichtung nach Anspruch 1 oder 2, wobei der Pull-up-Transistor konfiguriert ist, zum Empfangen des Eingangswertes an einem Gate-Anschluss, und
wobei die Speichervorrichtung (100, 200) ferner konfiguriert ist, zum Auswählen der einen Operation zwischen der ersten Operation und der zweiten Operation basierend entweder auf einer Betriebsfrequenz der Speichervorrichtung (100, 200) oder einer Leckage.

4. Speichervorrichtung nach einem der Ansprüche 1 bis 3, ferner umfassend eines oder mehrere von:

einem Addierer (230), verbunden mit einem Ausgangsende der Multiplikationszelle (210, 310) und konfiguriert, zum Addieren eines inversen Wertes eines von der Multiplikationszelle (210, 310) ausgegebenen Signals, und
einer globalen Bitleitung und einem Schalter für eine Leseoperation oder eine Schreiboperation auf das Gewicht der Speicherzelle (311) durch Zugriff auf die Speicherzelle (311) der Multiplikationszelle (210, 310).

5. Speichervorrichtung nach einem der Ansprüche 1 bis 4, wobei die Multiplikationszelle (210, 310) Speicherzellen umfasst, die mit demselben Pull-up-Transistor verbunden sind, und die Speichervorrichtung (100, 200) ferner einen Eingangs-/Wortleitungsbetreiber (220) umfasst, der konfiguriert ist, zum Auswählen einer Speicherzelle (311) aus den Speicherzellen, die für eine Zielmultiplikationsoperation zu verwenden ist, und
wobei der Eingangs-/Wortleitungsbetreiber (220) eine Dekodierschaltung umfasst, die konfiguriert ist, zum Dekodieren eines Eingangswerts, der an die Multiplikationszelle (210, 310) geliefert wird, aus einem Eingangssignal und aus einem Signal, das die Speicherzelle (311) bestimmt, die für die Zielmultiplikationsoperation zu verwenden ist.

6. Speichervorrichtung nach einem der Ansprüche 1 bis 5, wobei die Multiplikationszelle (210, 310) Speicherzellen umfasst, die mit demselben Pull-up-Transistor verbunden sind, und die Speichervorrichtung (100, 200) ferner konfiguriert ist, zum Ausführen eines oder mehrerer der folgenden Schritte:

Aktivieren einer Wortleitung, die mit einer Speicherzelle (311) verbunden ist, die einen Wert entsprechend einer Zieloperation unter Speicherzellen speichert, die in einer Multiplikationszelle enthalten sind, und Deaktivieren einer Wortleitung, die mit einer Speicherzelle (311) unter den Speicherzellen verbunden ist, die eine andere ist als die Speicherzelle (311) der aktivierten Wortleitung,

Auswählen einer ersten Speicherzelle aus den Speicherzellen für eine erste Operation unter einer Vielzahl von Operationen und Ausgeben eines Signals entsprechend einem Multiplikationsergebnis durch denselben Pull-up-Transistor, und

Auswählen einer zweiten Speicherzelle aus den Speicherzellen für eine zweite Operation unter der Vielzahl von Operationen und Ausgeben eines Signals entsprechend einem Multiplikationsergebnis durch denselben Pull-up-Transistor.

7. Speichervorrichtung nach einem der Ansprüche 1 bis 6, ferner umfassend:

Multiplikationszellen, die die Multiplikationszelle (210, 310) enthalten, und konfiguriert, zum:

Ausführen einer Multiplikationsoperation in jeder der Multiplikationszellen parallel mit anderen Multiplikationszellen; und

Addieren, in dem gleichen Addierer, von Ausgängen von Multiplikationszellen, die mit der gleichen Spaltenleitung unter der Vielzahl von Multiplikationszellen verbunden sind, und

ferner konfiguriert zum, Speichern eines Akkumulatoroperationsergebnisses für das Eingangssignal in einem Ausgangsregister, wenn ein Eingangssignal empfangen wird, das einem letzten Bit eines einzelnen Bits oder mehrerer Bits entspricht.

8. Speichervorrichtung nach einem der Ansprüche 1 bis 7, wobei die Multiplikationszelle (210, 310) mit einem Paar von lokalen Bitleitungen verbunden ist,

wobei eine erste Speicherzelle unter den Speicherzellen, die in der Multiplikationszelle (210, 310) enthalten sind, mit einer ersten lokalen Bitleitung verbunden ist, und

eine zweite Speicherzelle unter der Vielzahl der Speicherzellen, die mit einer zweiten lokalen Bitleitung verbunden ist,

wobei die erste Speicherzelle, die mit der ersten lokalen Bitleitung verbunden ist, einen Wert aufweist, der einem Gewicht eines neuronalen Netzwerks entspricht, und

die zweite Speicherzelle, die mit der zweiten lokalen Bitleitung verbunden ist, einen inversen Wert des Gewichts aufweist.

9. Speichervorrichtung nach einem der Ansprüche 1 bis 8, ferner umfassend eines oder mehrere von:

einem Akkumulator (241), konfiguriert zum Speichern einer Ausgabe eines Addierers (230), konfiguriert zum Addieren von Multiplikationsergebnissen der Multiplikationszelle (210, 310) und zum Akkumulieren von Ergebnissen der Addition,

einem Ausgaberegister, konfiguriert zum Speichern eines endgültigen Ergebnisses der Operation der Multiplikation, das von dem Akkumulator (241) ausgegeben wird, und

einer Speichersteuerung (290), konfiguriert zum Steuern der Multiplikationszelle (210, 310), eines Eingangs-/Wortleitungsbetreibers (220), einer Lese-/Schreibschaltung (280), eines Addierers, eines Akkumulators und eines Ausgangsregisters (242).

10. Speichervorrichtung nach einem der Ansprüche 1 bis 9, ferner konfiguriert zum Ausführen einer Operation für eine Vorladung an einem Ausgangsende eines Pull-up-Transistors als Reaktion darauf, dass entweder eine voreingestellte Periode verstrichen ist oder eine Multiplikationsoperation unter Verwendung einer anderen Speicherzelle in jeder Multiplikationszelle (210, 310) durchgeführt wird.

11. Speichervorrichtung nach Anspruch 3, wobei:

das Gate des Pull-up-Transistors (319) mit einer Ausgangsleitung (LBLB) verbunden ist;

der erste Transistor (TR1) als ein Zellentransistor konfiguriert ist, der ein Gate aufweist und mit dem ersten Ende des Inverterpaares (INV1, INV2) und mit der Ausgangsleitung (LBLB) verbunden ist; und

als Reaktion auf einen Eingang mit demselben Logikwert, der an das Gate des Pull-up-Transistors (319) und das Gate des Zellentransistors (TR1) angelegt wird, konfiguriert ist, zum Ausgeben an die Ausgangsleitung (LBLB) eines Logikwertes entsprechend einem binären Multiplikationsergebnis zwischen dem Eingang und einem binären Wert, der in der Speicherzelle (210, 310) gespeichert ist.

21

**12.** Speichervorrichtung nach Anspruch 11, wobei der Logikwert dem binären Multiplikationsergebnis entspricht und ein NAND-Ergebnis ist,

wobei der Pull-up-Transistor (319) ein P-Typ-Metalloxid-Halbleiter, PMOS-Transistor, ist und der Zellentransistor ein N-Typ-Metalloxid-Halbleiter, NMOS-Transistor, ist, oder
wobei die Speicherzelle (210, 310) eine von mehreren Speicherzellen ist, die mit der Ausgangsleitung (LBLB) verbunden sind.

**13.** Speichervorrichtung nach Anspruch 11 oder 12, wobei das Multiplikationsergebnis entweder jeden Taktzyklus oder nur alle zwei Taktzyklen ausgegeben wird.

**14.** Speichervorrichtung nach einem der Ansprüche 11 bis 13, wobei der Zellentransistor ein erster Zellentransistor ist und die Speicherzelle ferner einen zweiten Zellentransistor umfasst, der ein Gate aufweist und mit dem zweiten Ende des Inverterpaares verbunden ist, wobei ein Eingang mit demselben Logikwert an das Gate des zweiten Zellentransistors angelegt wird, oder
wobei die Ausgangsleitung eine erste Ausgangsleitung (LBLB) ist, die ferner eine zweite Ausgangsleitung (LBL) umfasst, wobei der Zellentransistor ein erster Zellentransistor ist und die Speicherzelle ferner einen zweiten Zellentransistor umfasst, der ein Gate aufweist und mit dem anderen Ende des Inverterpaares und mit der zweiten Ausgangsleitung verbunden ist, wobei der Pull-up-Transistor ein erster Pull-up-Transistor ist, und wobei die Speichervorrichtung (100, 200) ferner einen zweiten Pull-up-Transistor umfasst, der mit der zweiten Ausgangsleitung verbunden ist, und wobei die Speicherzelle eine von mehreren Speicherzellen ist, die mit der ersten Ausgangsleitung und der zweiten Ausgangsleitung verbunden sind.

**15.** Verfahren zum Betreiben einer Speichervorrichtung (100, 200), wobei das Verfahren umfasst:

Empfangen eines Eingangswerts über eine Wortleitung (WLm) durch eine Speicherzelle (311), die zwei Inverter (INV1, INV2) umfasst, die in entgegengesetzten Richtungen relativ zueinander miteinander verbunden sind, und zwei Transistoren (TR1, TR2), die mit beiden Enden der beiden Inverter verbunden sind;
Empfangen des Eingangswerts an einem Gate-Anschluss durch einen Pull-up-Transistor (319), der mit einem Ausgangsende der Speicherzelle (311) verbunden ist;
Auswählen, durch den Pull-up-Transistor (319), einer Operation aus einer ersten Operation und einer zweiten Operation und Ausführen der ausgewählten Operation und Schalten in Reaktion auf einen Eingangswert und Ausgeben eines Signals, das einem Multiplikationsergebnis zwischen dem Eingangswert und dem gespeicherten Wert entspricht; und
Ausgeben eines Signals, das einem Multiplikationsergebnis zwischen dem Eingabewert und einem in der Speicherzelle (311) gespeicherten Gewicht entspricht, von einem Ausgangsende des Pull-up-Transistors (319), wobei die erste Operation das Steuern einer Spannung an einem Ausgangsende des Pull-up-Transistors (319) auf eine Versorgungsspannung als Reaktion auf eine Spannung, die geringer ist als die Versorgungsspannung, die durch eine Wortleitung (WLm) in einigen Multiplikationsoperationen in einer Reihe von Multiplikationsoperationen angelegt wird, und das Ausgeben jedes Mal eines Multiplikationsoperationsergebnisses gemäß einer der Speichervorrichtung (100, 200) zugeführten Eingabe umfasst, und
wobei die zweite Operation das Steuern einer Spannung am Ausgangsende des Pull-up-Transistors (319) auf die Versorgungsspannung in einer Vorladephase für jede Multiplikationsoperation und das Ausführen einer Multiplikationsoperation in einer Auswertungsphase umfasst.

**Revendications**

**1.** Dispositif de mémoire, comprenant :
une cellule de multiplication (210, 310) comprenant :

une cellule de mémoire (311) dans laquelle une valeur est stockée, dans lequel la cellule de mémoire (311) comprend une paire d'onduleurs (INV1, INV2) comprenant

un premier onduleur (INV1) et un second onduleur (INV2), chaque onduleur comprenant une entrée et une sortie, dans lequel l'entrée du premier onduleur est connectée à la sortie du second onduleur à une première extrémité de la paire d'onduleurs, et dans lequel la sortie du premier onduleur étant connectée à l'entrée du second onduleur à une seconde extrémité de la paire d'onduleurs,

un premier transistor (TR1) connecté à la première extrémité (QB) de la paire d'onduleurs, et
un second transistor (TR2) connecté à la seconde extrémité (Q) de la paire d'onduleurs ; et
un élément de commutation (319) configuré sous forme d'un transistor d'excursion haute et connecté à une extrémité de sortie ($N_{out}$) de la cellule de mémoire (311), le transistor d'excursion haute (319) étant configuré pour sélectionner une opération parmi une première opération et une seconde opération et effectuer l'opération sélectionnée, et pour effectuer une commutation en réponse à une valeur d'entrée et délivrer en sortie un signal correspondant à un résultat de multiplication entre la valeur d'entrée et la valeur stockée,

dans lequel la première opération comprend l'entraînement d'une tension à une extrémité de sortie du transistor d'excursion haute (319) à une tension d'alimentation en réponse à une tension inférieure à la tension d'alimentation qui est appliquée via une ligne de mots ($WL_m$) dans certaines opérations de multiplication d'une série d'opérations de multiplication, et la sortie à chaque fois d'un résultat d'opération de multiplication selon une entrée fournie au dispositif de mémoire (100, 200), et
dans lequel la seconde opération comprend l'entraînement d'une tension à l'extrémité de sortie du transistor d'excursion haute (319) à la tension d'alimentation lors d'une phase de précharge pour chaque opération de multiplication, et la réalisation d'une opération de multiplication lors d'une phase d'évaluation.

2. Dispositif de mémoire selon la revendication 1, dans lequel l'élément de commutation (319) est configuré pour, lorsqu'il est connecté entre une tension d'alimentation et l'extrémité de sortie de la cellule de mémoire (311) :

être bloqué en réponse à une valeur logique égale à un reçue en tant que valeur d'entrée ; et
être passant en réponse à une valeur logique égale à zéro reçue en tant que valeur d'entrée, et/ou
dans lequel le transistor d'excursion haute est configuré pour recevoir la valeur d'entrée au niveau d'une borne de grille, dans lequel le premier transistor (TR1) et le second transistor (TR2) sont chacun un transistor métal-oxyde-semiconducteur de type N, NMOS, et dans lequel le transistor d'excursion haute (319) est un transistor métal-oxyde-semiconducteur de type P, PMOS.

3. Dispositif de mémoire selon la revendication 1 ou 2, dans lequel le transistor d'excursion haute est configuré pour recevoir la valeur d'entrée au niveau d'une borne de grille, et
dans lequel le dispositif de mémoire (100, 200) est en outre configuré pour sélectionner ladite une opération parmi la première opération et la seconde opération sur la base d'une fréquence de fonctionnement du dispositif de mémoire (100, 200) ou d'une fuite.

4. Dispositif de mémoire selon l'une des revendications 1 à 3, comprenant en outre un ou plusieurs éléments parmi :

un additionneur (230) connecté à une extrémité de sortie de la cellule de multiplication (210, 310) et configuré pour additionner une valeur inverse d'un signal délivré en sortie par la cellule de multiplication (210, 310), et
une ligne de bits globale et un commutateur pour une opération de lecture ou une opération d'écriture sur le poids de la cellule de mémoire (311) via accès à la cellule de mémoire (311) de la cellule de multiplication (210, 310).

5. Dispositif de mémoire selon l'une des revendications 1 à 4, dans lequel la cellule de multiplication (210, 310) comprend des cellules de mémoire connectées au même transistor d'excursion haute, et le dispositif de mémoire (100, 200) comprend en outre un circuit d'attaque de ligne d'entrée/mots (220) configuré pour sélectionner, parmi les cellules de mémoire, une cellule de mémoire (311) à utiliser pour une opération de multiplication cible, et
dans lequel le circuit d'attaque de ligne d'entrée/mots (220) comprend un circuit de décodage configuré pour décoder une valeur d'entrée fournie à la cellule de multiplication (210, 310) à partir d'un signal d'entrée et d'un signal désignant la cellule de mémoire (311) à utiliser pour l'opération de multiplication cible.

6. Dispositif de mémoire selon l'une des revendications 1 à 5, dans lequel la cellule de multiplication (210, 310) comprend des cellules de mémoire connectées au même transistor d'excursion haute, et le dispositif de mémoire (100, 200) est en outre configuré pour effectuer une ou plusieurs des opérations suivantes :

l'activation d'une ligne de mots connectée à une cellule de mémoire (311) stockant une valeur correspondant à une opération cible parmi des cellules de mémoire comprises dans une cellule de multiplication, et la désactivation d'une ligne de mots connectée à une cellule de mémoire (311), parmi les cellules de mémoire, autre que la cellule de mémoire (311) de la ligne de mots activée,
la sélection d'une première cellule de mémoire parmi les cellules de mémoire pour une première opération parmi une pluralité d'opérations et la sortie d'un signal correspondant à un résultat de multiplication via le même transistor d'excursion haute, et

la sélection d'une seconde cellule de mémoire parmi les cellules de mémoire pour une seconde opération parmi la pluralité d'opérations et la sortie d'un signal correspondant à un résultat de multiplication via le même transistor d'excursion haute.

**7.** Dispositif de mémoire selon l'une des revendications 1 à 6, comprenant en outre :

des cellules de multiplication comportant la cellule de multiplication (210, 310), et
configurées pour :

effectuer une opération de multiplication dans chacune des cellules de multiplication en parallèle avec d'autres cellules de multiplication ; et
additionner, dans le même additionneur, des sorties de cellules de multiplication connectées à la même ligne de colonne parmi la pluralité de cellules de multiplication, et

configurées en outre pour, lors de la réception d'un signal d'entrée correspondant à un dernier bit d'un bit unique ou de multiples bits, stocker un résultat d'opération d'accumulateur pour le signal d'entrée dans un registre de sortie.

**8.** Dispositif de mémoire selon l'une des revendications 1 à 7, dans lequel la cellule de multiplication (210, 310) est connectée à une paire de lignes de bits locales,

dans lequel une première cellule de mémoire parmi des cellules de mémoire comprises dans la cellule de multiplication (210, 310) est connectée à une première ligne de bits locale, et
une seconde cellule de mémoire parmi la pluralité de cellules de mémoire est connectée à une seconde ligne de bits locale,
dans lequel la première cellule de mémoire connectée à la première ligne de bits locale a une valeur correspondant à un poids d'un réseau neuronal, et
la seconde cellule de mémoire connectée à la seconde ligne de bits locale a une valeur inverse du poids.

**9.** Dispositif de mémoire selon l'une des revendications 1 à 8, comprenant en outre un ou plusieurs éléments parmi :

un accumulateur (241) configuré pour stocker une sortie d'un additionneur (230) configuré pour additionner des résultats de multiplication de la cellule de multiplication (210, 310), et accumuler des résultats de l'addition,
un registre de sortie configuré pour stocker un résultat d'opération de multiplication final délivré en sortie par l'accumulateur (241), et
un dispositif de commande de mémoire (290) configuré pour commander la cellule de multiplication (210, 310), un circuit d'attaque de ligne d'entrée/mots (220), un circuit de lecture/écriture (280), un additionneur, un accumulateur, et un registre de sortie (242).

**10.** Dispositif de mémoire selon l'une des revendications 1 à 9, configuré en outre pour, en réponse au fait qu'une période prédéfinie s'est écoulée ou qu'une opération de multiplication utilisant une autre cellule de mémoire est effectuée dans chaque cellule de multiplication (210, 310), effectuer une opération de précharge sur une extrémité de sortie d'un transistor d'excursion haute.

**11.** Dispositif de mémoire selon la revendication 3, dans lequel :

la grille du transistor d'excursion haute (319) est connectée à une ligne de sortie (LBLB) ;
le premier transistor (TR1) est configuré sous forme d'un transistor de cellule ayant une grille et connecté à la première extrémité de la paire d'onduleurs (INV1, INV2) et à la ligne de sortie (LBLB) ; et
en réponse à une entrée ayant la même valeur logique qui est appliquée à la grille du transistor d'excursion haute (319) et à la grille du transistor de cellule (TR1), est configuré pour délivrer en sortie, dans la ligne de sortie (LBLB), une valeur logique correspondant à un résultat de multiplication binaire entre l'entrée et une valeur binaire stockée dans la cellule de mémoire (210, 310).

**12.** Dispositif de mémoire selon la revendication 11, dans lequel la valeur logique correspondant au résultat de multiplication binaire est un résultat NON-ET,

dans lequel le transistor d'excursion haute (319) est un transistor métal-oxyde-semiconducteur de type P, PMOS, et le transistor de cellule est un transistor métal-oxyde-semiconducteur de type N, NMOS, ou

dans lequel la cellule de mémoire (210, 310) est l'une de multiples cellules de mémoire connectées à la ligne de sortie (LBLB).

13. Dispositif de mémoire selon la revendication 11 ou 12, dans lequel le résultat de multiplication est délivré en sortie à chaque cycle d'horloge, ou seulement tous les deux cycles d'horloge.

14. Dispositif de mémoire selon l'une des revendications 11 à 13, dans lequel le transistor de cellule est un premier transistor de cellule, et la cellule de mémoire comprend en outre un second transistor de cellule ayant une grille et connecté à la seconde extrémité de la paire d'onduleurs, dans lequel une entrée ayant la même valeur logique est appliquée à la grille du second transistor de cellule, ou

dans lequel la ligne de sortie est une première ligne de sortie (LBLB) comprenant en outre une seconde ligne de sortie (LBL), dans lequel le transistor de cellule est un premier transistor de cellule, et la cellule de mémoire comprend en outre un second transistor de cellule ayant une grille et connecté à l'autre extrémité de la paire d'onduleurs et à la seconde ligne de sortie, dans lequel le transistor d'excursion haute est un premier transistor d'excursion haute, et dans lequel le dispositif de mémoire (100, 200) comprend en outre un second transistor d'excursion haute connecté à la seconde ligne de sortie, et dans lequel la cellule de mémoire est l'une de multiples cellules de mémoire connectées à la première ligne de sortie et à la seconde ligne de sortie.

15. Procédé de fonctionnement d'un dispositif de mémoire (100, 200), le procédé comprenant :

la réception d'une valeur d'entrée via une ligne de mots ($WL_m$) par une cellule de mémoire (311) comprenant deux onduleurs (INV1, INV2) connectés l'un à l'autre dans des directions opposées l'une par rapport à l'autre, et deux transistors (TR1, TR2) connectés aux deux extrémités des deux onduleurs ;

la réception de la valeur d'entrée au niveau d'une borne de grille par un transistor d'excursion haute (319) connecté à une extrémité de sortie de la cellule de mémoire (311) ;

la sélection, par le transistor d'excursion haute (319), d'une opération parmi une première opération et une seconde opération et la réalisation de l'opération sélectionnée, et la commutation en réponse à une valeur d'entrée et une sortie d'un signal correspondant à un résultat de multiplication entre la valeur d'entrée et la valeur stockée ; et

la sortie, à partir d'une extrémité de sortie du transistor d'excursion haute (319), d'un signal correspondant à un résultat de multiplication entre la valeur d'entrée et un poids stocké dans la cellule de mémoire (311),

dans lequel la première opération comprend l'entraînement d'une tension à une extrémité de sortie du transistor d'excursion haute (319) à une tension d'alimentation en réponse à une tension inférieure à la tension d'alimentation qui est appliquée via une ligne de mots ($WL_m$) dans certaines opérations de multiplication d'une série d'opérations de multiplication, et la sortie à chaque fois d'un résultat d'opération de multiplication selon une entrée fournie au dispositif de mémoire (100, 200), et

dans lequel la seconde opération comprend l'entraînement d'une tension à l'extrémité de sortie du transistor d'excursion haute (319) à la tension d'alimentation lors d'une phase de précharge pour chaque opération de multiplication, et la réalisation d'une opération de multiplication lors d'une phase d'évaluation.

FIG. 1

FIG. 2

310 →

PU

$WL_m$

INV1

TR2

Q  INV2  QB

TR1

$N_{out}$

319

LBL

311

LBLB

| PU, $WL_m$ | Q | LBLB |
|---|---|---|
| 0 | 0 | 1 |
| 0 | 1 | 1 |
| 1 | 0 | 1 |
| 1 | 1 | 0 |

390

FIG. 3A

FIG. 3B

| WL_m, PU | Q | LBLB | |
|---|---|---|---|
| 0 | 0 | 1 | 390b |

FIG. 3C

| WL_m, PU | Q | LBLB | |
|---|---|---|---|
| 0 | 1 | 1 | 390c |

FIG. 3D

| WL$_m$, PU | Q | LBLB | |
|:---:|:---:|:---:|---|
| 1 | 0 | 1 | 390d |

FIG. 3E

| WL$_m$, PU | Q | LBLB | |
|:---:|:---:|:---:|---|
| 1 | 1 | 0 | 390e |

FIG. 3F

FIG. 4

FIG. 5

FIG. 6A

690b

FIG. 6B

FIG. 7

$\overline{IN_m \times Q_{m,i}} = P_{m,i}$

$PU_m = IN_m$

$WL_{m,i} = IN_m$

$WL_{m,k} = 0$
(for $k \neq i$)

IN/WL driver 720

Read/write circuit

Adder 730

Adder

Outputter 740

710

790

$$\overline{IN_m \times Q_{m,i}} = RP$$

$$\overline{IN_m \times \overline{Q_{m,j}}} = LP$$

$PU_m = IN_m$

$RWL_{m,i} = IN_m$

$RWL_{m,k} = 0$

(for $k \neq i$)

$LWL_{m,j} = IN_m$

$LWL_{m,p} = 0$

(for $p \neq j$)

FIG. 8

FIG. 9

FIG. 10

FIG. 11

1200

CPU <u>1220</u>

HS <u>1221</u>

RAM <u>1230</u>

Logic Block <u>1240</u>

Logic Block <u>1240</u>

HD IMC Macro <u>1210</u>

HE IMC Macro <u>1250</u>

HE IMC Macro <u>1250</u>

FIG. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 114613404 A
- US 2009086528 A1
- US 11176991 B1